(19) 

**Europäisches Patentamt**
**European Patent Office**
**Office européen des brevets**

(11) **EP 2 635 091 A1**

(12) # EUROPEAN PATENT APPLICATION
published in accordance with Art. 153(4) EPC

(43) Date of publication:
**04.09.2013 Bulletin 2013/36**

(21) Application number: **11836177.3**

(22) Date of filing: **21.10.2011**

(51) Int Cl.:
*H05B 33/02* (2006.01)          *H01L 51/50* (2006.01)
*H05B 33/10* (2006.01)

(86) International application number:
**PCT/JP2011/074358**

(87) International publication number:
**WO 2012/057043 (03.05.2012 Gazette 2012/18)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.04.2011   JP 2011101847**
**25.10.2010   JP 2010238983**

(71) Applicant: **Asahi Glass Company, Limited**
**Tokyo 100-8405 (JP)**

(72) Inventors:
• **NAKAMURA, Nobuhiro**
**Tokyo 100-8405 (JP)**

• **YAMADA, Tomohiro**
**Tokyo 100-8405 (JP)**
• **ONO, Motoshi**
**Tokyo 100-8405 (JP)**
• **ISHIBASHI, Nao**
**Tokyo 100-8405 (JP)**
• **SUZUKI, Susumu**
**Tokyo 100-8405 (JP)**

(74) Representative: **Müller-Boré & Partner**
**Patentanwälte**
**Grafinger Straße 2**
**81671 München (DE)**

(54) **ORGANIC EL DEVICE, TRANSLUCENT SUBSTRATE, AND METHOD FOR MANUFACTURING ORGANIC EL DEVICE**

(57)    An organic EL element includes a transparent substrate; a first electrode; an organic light emitting layer formed on the first electrode; and a second electrode formed on the organic light emitting layer, wherein a scattering layer including a base material made of glass and scattering substances dispersed in the base material is provided on the transparent substrate, and a light extraction assistance layer is provided between the scattering layer and the first electrode, the light extraction assistance layer being made of an inorganic material other than glass.

FIG.1

**Description**

BACKGROUND OF THE INVENTION

1. Field of the Invention

The present invention relates to an organic EL element, a translucent substrate and a method of manufacturing an organic EL element.

2. Description of the Related Art

An organic Electro Luminescence (organic EL) element is widely used for a display, a backlight, an illumination and the like.

A general purpose organic EL element includes a first electrode (anode) formed on a substrate, a second electrode (cathode) and an organic layer provided between these electrodes. When applying a voltage between the electrodes, holes and electrons are injected into the organic layer from each of the electrodes. When the holes and the electrodes are recombined in the organic layer, a binding energy is generated to excite luminescent materials in the organic layer. As light emissions occur when the excited luminescent materials return to the ground state, a luminescent (EL) element is obtained by using this phenomenon.

Generally, a transparent thin layer such as Indium Tin Oxide (which will be simply referred to as "ITO" hereinafter) is used for the first electrode, the anode in other words, and a metal thin layer such as aluminum, silver or the like is used for the second electrode, the cathode in other words.

It has been suggested recently to provide a scattering layer including scattering substances between the ITO electrode and the substrate (Patent Document 1, for example). In such a structure, it is disclosed that a part of the light emissions occurring in the organic layer is scattered by the scattering substances in the scattering layer so that the light quantity of the light trapped in the ITO electrode or the substrate (the light quantity of totally reflected light) can be decreased to increase a light extracting efficiency of the organic EL element.

Further, a structure of an organic EL element is disclosed in which a glass sintered layer (scattering layer) is provided on a glass plate with a convexo-concave surface, and a protection layer is provided between the glass sintered layer and a transparent conductive layer (first electrode) (Patent Document 2).

[References]

[Patent Document]

[Patent Document 1] WO 2009/060916 A1
[Patent Document 2] Japanese Laid-open Patent Publication No. 2010-198797

As described above, the organic EL element including the scattering layer has been suggested. However, for the organic EL element, it is required to further improve the light extracting efficiency.

The present invention is made in light of the above problems, and provides an organic EL element and a method of manufacturing the organic EL element whose light extracting efficiency is improved. Further, the present invention provides a translucent substrate for such an organic EL element.

SUMMARY OF THE INVENTION

According to an embodiment, there is provided an organic EL element including a transparent substrate; a first electrode; an organic light emitting layer formed on the first electrode; and a second electrode formed on the organic light emitting layer, wherein a scattering layer including a base material made of glass and scattering substances dispersed in the base material is provided on the transparent substrate, and a light extraction assistance layer is provided between the scattering layer and the first electrode, the light extraction assistance layer being made of an inorganic material other than glass.

According to another embodiment, for the organic EL element, the light extraction assistance layer may have a refraction index more than or equal to 2.2 within a wavelength range of 430 nm to 650 nm.

According to another embodiment, for the organic EL element, the light extraction assistance layer may be made of a material selected from a group including Ti containing nitride, Ti containing oxide and Ti containing nitride-oxide.

According to another embodiment, for the organic EL element, the light extraction assistance layer may be made of $TiZr_xO_y$ or $TiO_2$.

According to another embodiment, for the organic EL element, the thickness of the light extraction assistance layer may be less than or equal to 50 nm.

According to another embodiment, there is provided a translucent substrate including a transparent substrate and a transparent electrode, wherein a scattering layer including a base material made of glass and scattering substances dispersed in the base material is provided on the transparent substrate, and a light extraction assistance layer is provided between the scattering layer and the transparent electrode, the light extraction assistance layer being made of an inorganic material other than glass.

According to another embodiment, for the translucent substrate, the light extraction assistance layer may have a refraction index more than or equal to 2.2 within a wavelength range of 430 nm to 650 nm.

According to another embodiment, there is provided a method of manufacturing an organic EL element, including forming a scattering layer on a transparent substrate; providing a light extraction assistance layer on the scattering layer; providing a first electrode on the light extraction assistance layer; providing an organic light emitting layer on the first electrode; and providing a second electrode on the organic light emitting layer.

According to another embodiment, the light extraction assistance layer may be provided to have a refraction index more than or equal to 2.2 within a wavelength range of 430 nm to 650 nm.

According to another embodiment, the light extraction assistance layer may be provided to be made of a material selected from a group including Ti containing nitride, Ti containing oxide and Ti containing nitride-oxide.

According to another embodiment, the light extraction assistance layer may be provided to be made of $TiZr_xO_y$ or $TiO_2$.

According to another embodiment, the light extraction assistance layer may be provided such that the thickness of which becomes less than or equal to 50 nm.

Other objects, features and advantages of the present invention will become more apparent from the following detailed description when read in conjunction with the accompanying drawings.

According to the embodiments, an organic EL element and a method of manufacturing an organic EL element whose light extracting efficiency is improved are provided. Further, a translucent substrate for such an organic EL element is provided.

BRIEF DESCRIPTION OF THE DRAWINGS

Fig. 1 is a schematic cross-sectional view showing an example of a structure of an organic EL element of an embodiment;

Fig. 2 is a flowchart schematically showing an example of a method of manufacturing the organic EL element of the embodiment;

Fig. 3 is a schematic top view of a scattering layer substrate in which a scattering layer was provided on a soda lime substrate in a first example of the embodiment;

Fig. 4 is a schematic top view of a light extraction assistance layer substrate of the first example of the embodiment;

Fig. 5 is a schematic top view of the light extraction assistance layer substrate on which the ITO layer was provided, according to the first example of the embodiment;

Fig. 6 is a graph showing the wavelength dependency of the refraction index of the $TiZr_xO_y$ layer, according to the first example of the embodiment;

Fig. 7 is a schematic top view of the translucent substrate after the organic light emitting layer or the like was deposited, according to the first example of the embodiment;

Fig. 8 is a view showing current-voltage characteristics of the organic EL elements obtained as samples A1 to A4, according to the first example of the embodiment;

Fig. 9 is a view showing current-luminous flux characteristics of the organic EL elements obtained as the samples A1 to A4, according to the first example of the embodiment;

Fig. 10 is a view schematically showing a measurement device for evaluating the angular dependency of the light emission and the chromaticity for the samples, according to the first example of the embodiment;

Fig. 11 is a graph showing the luminance of the samples A1 to A4 in accordance with the angle variation, according to the first example of the embodiment;

Fig. 12 is a graph showing the chromaticity of the samples A1 to A4 in accordance with the angle variation, according to the first example of the embodiment;

Fig. 13 is a view showing current-luminous flux characteristics of the organic EL elements obtained as the samples B1 to B4, according to the first example of the embodiment;

Fig. 14 is a graph showing the angular dependency of the luminance of the samples B1 to B4, according to the first example of the embodiment;

Fig. 15 is a view showing a structure of an organic EL element that is used in a calculation as a basis of a second example of the embodiment;

Fig. 16 is a view showing a structure of an organic EL element that is used in the calculation and includes a scattering layer;

Fig. 17 is a view showing a structure of an organic EL element that is used in the calculation and includes a scattering layer and a light extraction assistance layer;

Fig. 18A is a view showing a calculation result of frontal luminance obtained for the organic EL element shown in Fig. 15, where the indicated color calculation result was converted to grayscale;

Fig. 18B is a view showing a calculation result of frontal luminance obtained for the organic EL element shown in Fig. 15, where the indicated color calculation result was converted to rough patterns;

Fig. 19A is a view showing a calculation result of frontal luminance obtained for the organic EL element shown in Fig. 16, where the indicated color calculation result was converted to grayscale;

Fig. 19B is a view showing a calculation result of frontal luminance obtained for the organic EL element shown in Fig. 16, where the indicated color calculation result was converted to rough patterns;

Fig. 20A is a view showing a calculation result of frontal luminance obtained for the organic EL element shown in Fig. 17, where the indicated color calculation result was converted to grayscale;

Fig. 20B is a view showing a calculation result of frontal luminance obtained for the organic EL element shown in Fig. 17, where the indicated color calculation result was converted to rough patterns;

Fig. 21 is a schematic cross-sectional view of the organic EL element of sample 1;

Fig. 22 is a schematic cross-sectional view of the organic EL element of sample 2; and

Fig. 23 is a schematic cross-sectional view of the organic EL element of sample 3.

## DETAILED DESCRIPTION OF THE PREFERRED EMBODIMENTS

The invention will be described herein with reference to illustrative embodiments.

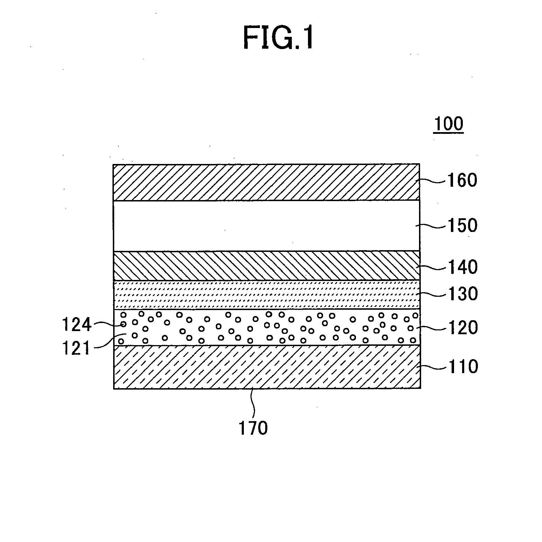

Fig. 1 is a schematic cross-sectional view showing an example of a structure of an organic EL element of the embodiment.

As shown in Fig. 1, the organic EL element 100 of the embodiment includes a transparent substrate 110, a scattering layer 120, a light extraction assistance layer 130, a first electrode (anode) 140, an organic light emitting layer 150, and a second electrode (cathode) 160 stacked in this order. For the example shown in Fig. 1, a surface at a lower side (an exposed surface of the transparent substrate 110) of the organic EL element 100 is a light extraction surface 170.

The transparent substrate 110 is made of a glass substrate or a plastic substrate, for example.

The first electrode 140 is made of a transparent metal oxide thin film such as ITO, for example, and the thickness of which is about 50 nm to 1.0 $\mu$m. On the other hand, the second electrode 160 is made of a metal such as aluminum or silver, for example.

The organic light emitting layer 40 is, generally, composed of multiple layers such as an electron transport layer, an electron injection layer, a hole transport layer, a hole injection layer and the like in addition to a light emitting layer.

The scattering layer 120 includes a base material 121 made of glass and having a first refraction index, and scattering substances 124 dispersed in the base material 121 and having a second refraction index different from that of the base material 121. The scattering substances 124 are plural particles, plural pores in a material or the like. The thickness of the scattering layer 120 is within a range between 5 $\mu$m to 50 $\mu$m, for example. The scattering layer 120 has a function to reduce a reflection of light at an interface between a layer adjacent to the scattering layer 120 by scattering incident light.

The organic EL element of the embodiment includes the light extraction assistance layer 130 provided between the scattering layer 120 and the first electrode 140.

The light extraction assistance layer 130 is made of an inorganic material other than glass, and has a function to increase the light quantity of the light transmitted from the light extraction surface 170 by a cooperative operation with the scattering layer 120. It means that according to the organic EL element 100 of the embodiment, as will be explained in detail later, the light quantity of the light transmitted from the light extraction surface 170 can be significantly improved by the scattering layer 120 and the light extraction assistance layer 130.

When the base material 121 of the scattering layer 120 is made of glass including alkali metal (soda-lime glass or the like, for example), the light extraction assistance layer 130 also functions as a barrier layer between the scattering layer 120 and the first electrode 140. If the light extraction assistance layer 130 does not exist, the alkali metal in the scattering layer 120 may relatively easily move toward the first electrode 140 side when using the organic EL element 100. Such a movement of the alkali metal causes a deterioration of characteristics of the first electrode 140 (transparency, electrical conductivity or the like, for example). However, when the light extraction assistance layer 130 exists, the movement of the alkali metal from the scattering layer 120 toward the first electrode 140 can be suppressed.

The layers composing the organic EL element of the embodiment are explained in detail.

(Transparent substrate 110)

The transparent substrate 110 is made of a material having high transmittance to a visible light. The transparent substrate 110 may be, for example, a glass substrate, a plastic substrate or the like.

For the material of the glass substrate, an inorganic glass such as alkali glass, non-alkali glass (alkali-free glass), quartz glass or the like may be used. For the material of the plastic substrate, polyester, polycarbonate, polyether, polysulfone, polyether sulfone, polyvinyl alcohol, a fluorine-containing polymer such as polyvinylidene fluoride, polyvinyl fluoride or the like may be used.

The thickness of the transparent substrate 110 is not especially limited but may be, for example, within a range of 0.1 mm to 2.0 mm. When considering the strength and the weight, the thickness of the transparent substrate 110 may be, 0.5 mm to 1.4 mm.

(Scattering layer 120)

The scattering layer 120 includes the base material 121 and the scattering substances 124 dispersed in the base material 121. The base material 121 has the first refraction index, and the scattering substances 124 have the second refraction index different from that of the base material.

The base material 121 is made of glass. For the material of the glass, an inorganic glass such as soda-lime glass, borosilicate glass, non-alkali glass (alkali-free glass), quartz glass or the like may be used.

The scattering substances 124 may be made of, for example, pores of a material, precipitated crystals, particles of a material different from the base material, phase separated glass or the like. Phase separated glass means a glass composed of two or more kinds of glass phases after components composing the glass are separated into two or more kinds of structures.

It is preferable that the difference between the refraction indexes of the base material 121 and the scattering substances 124 is large. For this reason, it is preferable that a high refraction index glass is used for the base material 121 and pores of a material are used for the scattering substances 124.

For the high refraction index glass used for the base material 121, one or more components may be selected from $P_2O_5$, $SiO_2$, $B_2O_3$, $GeO_2$ and $TeO_2$ as a network former (in other words, for a framework structure or the like composing the glass) and one or more components may be selected from $TiO_2$, $Nb_2O_5$, $WO_3$, $Bi_2O_3$, $La_2O_3$, $Gd_2O_3$, $Y_2O_3$, $ZrO_2$, ZnO, BaO, PbO and $Sb_2O_3$ as a high refraction index component. Further in order to adjust characteristics of the glass, an alkali oxide, an alkaline earth oxide, a fluoride or the like may be added within a range not impairing characteristics for the refraction index.

Thus, for the glass system composing the base material 121, for example, a $B_2O_3$-ZnO-$La_2O_3$ system, a $P_2O_5$-$B_2O_3$-$R'_2O$-$R''O$-$TiO_2$-$Nb_2O_5$-$WO_3$-$Bi_2O_3$ system, a $TeO_2$-ZnO system, a $B_2O_3$-$Bi_2O_3$ system, a $SiO_2$-$Bi_2O_3$ system, a $SiO_2$-ZnO system, a $B_2O_3$-ZnO system, a $P_2O_5$-ZnO system or the like is exemplified. Here, R' represents an alkali metal element and R'' represents an alkaline earth metal element. The above material systems are examples and the materials to be used are not limited as long as satisfying the above-mentioned conditions.

Here, the refraction index of the base material 121 may be more than or equal to the refraction index of the first electrode 140. When the refraction index of the base material 121 is lower than that of the first electrode 140, there is caused a loss by the total reflection at an interface between the light extraction assistance layer 130 and the first electrode 140.

By adding a colorant in the base material 121, color of light emission can be changed. For the colorant, a transition metal oxide, a rare earth metal oxide, a metal colloid or the like may be used singly or in combination thereof.

According to the organic EL element 100 of the embodiment, fluorescent substances may be used for the base material 121 or the scattering substances 124. For this case, it is possible to change the color of the light emission from the organic light emitting layer 150 by a wavelength conversion. Further, for this case, it is possible to decrease the light emission colors of the organic EL element, and the emitted light is extracted after being scattered so that the angular dependency of color and/or changes in color with time can be suppressed. Such a structure is applicable for a backlight or a luminaire usage where a white light emission is necessary.

(Light extraction assistance layer 130)

The light extraction assistance layer 130 is made of an inorganic material other than glass.

It is preferable for the light extraction assistance layer 130 to have a refraction index more than or equal to 2.2 within a wavelength range of 430 nm to 650 nm, more preferable to have a refraction index more than or equal to 2.3 within a wavelength range of 430 nm to 650 nm, and further more preferable to have a refraction index more than or equal to 2.4 within a wavelength range of 430 nm to 650 nm.

The light extraction assistance layer 130 may be made of Ti containing oxide, Ti containing nitride, Ti containing nitride-oxide or the like, for example. For example, the light extraction assistance layer 130 may be made of $TiZr_xO_y$ or $TiO_2$.

The thickness of the light extraction assistance layer 130 is preferably less than or equal to 50 nm, and more preferably less than or equal to 40 nm. When the thickness of the light extraction assistance layer 130 exceeds 50 nm, the possibility that the light generated in the organic light emitting layer 150 is totally reflected by the light extraction assistance layer 130 becomes high.

(First electrode 140)

It is required for the first electrode 140 to have a translucency more than or equal to 80% for extracting the light generated in the organic light emitting layer 150 outside. Further, it is required for the first electrode 140 to have a high work function in order to inject a large amount of holes.

For the first electrode 140, a material such as ITO, $SnO_2$, ZnO, Indium Zinc Oxide (IZO), $ZnO-Al_2O_3$ (AZO: aluminum doped zinc oxide), $ZnO-Ga_2O_3$ (GZO: gallium doped zinc oxide), Nb doped $TiO_2$, Ta doped $TiO_2$ or the like may be used, for example.

The thickness of the first electrode 140 is preferably more than or equal to 100 nm.

The refraction index of the first electrode 140 is within a range of 1.9 to 2.2. For example, when ITO is used for the first electrode 140, it is possible to reduce the refraction index of the first electrode 140 by increasing the carrier concentration. Although the standard commercially available ITO includes 10 wt % of $SnO_2$, the refraction index of ITO can be reduced by further increasing the Sn concentration. However, note that although the carrier concentration is increased by increasing the Sn concentration, mobility and transmittance are lowered. Thus, it is necessary to determine the amount of Sn considering the total balance.

Further, it is preferable to determine the refraction index of the first electrode 140 considering the refraction index of the base material 121 composing the scattering layer 120 or the refraction index of the second electrode 160. It is preferable that the difference between the refraction indexes of the first electrode 140 and the base material 121 is less than or equal to 0.2 considering a calculation of waveguide, a reflectance of the second electrode 160 or the like.

(Organic light emitting layer 150)

The organic light emitting layer 150 has a function to emit light, and generally, includes a hole injection layer, a hole transport layer, a light emitting layer, an electron transport layer and an electron injection layer. Here, as long as the organic light emitting layer 150 includes the light emitting layer, it is not necessary to include all of the other layers. Generally, the refraction index of the organic light emitting layer 150 is within a range of 1.7 to 1.8.

It is preferable for the hole injection layer to have a small difference in ionization potential in order to lower a hole injection barrier from the first electrode 140. When the injection efficiency of electric charges from the electrode to the hole injection layer is increased, the drive voltage of the organic EL element 100 is lowered so that the injection efficiency of the electric charges is increased.

For the material of the hole injection layer, a high molecular material or a low molecular material is used. Among the high molecular materials, polyethylenedioxythiophene (PEDOT: PSS) doped with polystyrene sulfonic acid (PSS) may be used. Among the low molecular material, copper phthalocyanine (CuPc) of a phthalocyanine system may be used.

The hole transport layer has a function to transfer the holes injected by the hole injection layer to the light emitting layer. For the hole transport layer, a triphenylamine derivative, N,N'-Bis(1-naphthyl)-N,N'-Diphenyl-1,1'-biphenyl-4,4'-diamine (NPD), N,N'-Diphenyl-N,N'-Bis[N-phenyl-N-(2-naphtyl)-4'-aminobiphenyl-4-yl]-1,1'-biphenyl-4,4'-diamine (NPTE), 1,1'-bis[(di-4-tolylamino)phenyl]cyclohexane (HTM2), and N,N'-Diphenyl-N,N'-Bis(3-methylphenyl)-1,1'-diphenyl-4,4'-diamine (TPD) or the like may be used, for example.

The thickness of the hole transport layer is within a range of 10 nm to 150 nm, for example. The thinner the layer, the lower the voltage of the organic EL element can be. However, the thickness is generally within a range of 10 nm to 150 nm in view of an interelectrode short circuit problem.

The light emitting layer has a function to provide a field at which the injected electrons and the holes are recombined. For the organic luminescent material, a low molecular material or a high molecular material may be used.

The light emitting layer may be, for example, a metal complex of quinoline derivative such as tris(8-quinolinolate) aluminum complex ($Alq_3$), bis(8-hydroxy) quinaldine aluminum phenoxide (Alq'20Ph), bis(8-hydroxy) quinaldine aluminum-2,5-dimethylphenoxide (BAlq), mono(2,2,6,6-tetramethyl-3,5-heptanedionate)lithium complex (Liq), mono(8-quinolinolate)sodium complex (Naq), mono(2,2,6,6-tetramethyl-3,5-heptanedionate) lithium complex, mono(2,2,6,6-tetramethyl-3,5-heptanedionate) sodium complex, bis(8-quinolinolate) calcium complex ($Caq_2$) and the like, or a fluorescent substance such as tetraphenylbutadiene, phenylquinacridone (QD), anthracene, perylene, coronene and the like.

As for the host material, a quinolinolate complex may be used, especially, an aluminum complex having 8-quinolinol or a derivative thereof as a ligand may be used.

The electron transport layer has a function to transport electrons injected from the electrode. For the electron transport layer, for example, a quinolinol aluminum complex ($Alq_3$), an oxadiazole derivative (for example, 2,5-bis(1-naphthyl)-1,3,4-oxadiazole (END), 2-(4-t-butylphenyl)-5-(4-biphenyl)-1,3,4-oxadiazole (PBD) or the like), a triazole derivative, a bathophenanthroline derivative, a silole derivative or the like may be used.

The electron injection layer may be, for example, made by providing a layer in which alkali metal such as lithium (Li), cesium (Cs) or the like is doped at an interface with the second electrode 160.

(Second electrode 160)

For the second electrode 160, a metal with a small work function or the alloy thereof is used. The second electrode 160 may be, for example, alkali metal, alkaline earth metal, metals in group 3 of the periodic table and the like. The second electrode 160 may be, for example, aluminum (A1), magnesium (Mg), the alloy of these metals and the like.

Further, a co-vapor-deposited film of aluminum (A1) and magnesium silver (MgAg) or a laminated electrode in which aluminum (A1) is vapor-deposited on a thin layer of lithium fluoride (LiF) or lithium oxide ($Li_2O$) may be used. Further, a laminated layer of calcium (Ca) or barium (Ba) and aluminum (A1) may be used.

(Method of manufacturing organic EL element of the embodiment)

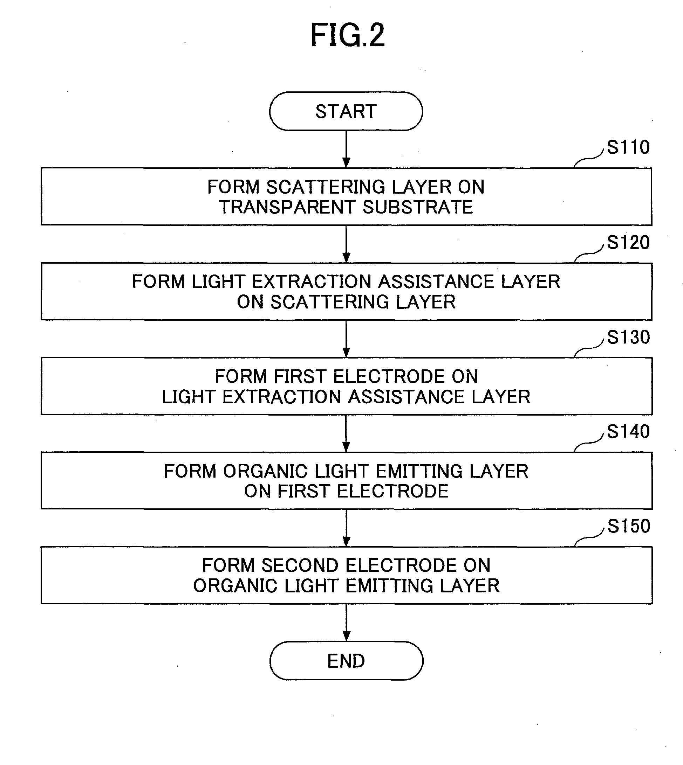

With reference to Fig. 2, an example of a method of manufacturing the organic EL element according to the embodiment is explained. Fig 2 is a flowchart schematically showing a method of manufacturing the organic EL element according to the embodiment.

As shown in Fig. 2, the method of manufacturing the organic EL element of the embodiment includes a step (step S110) in which the scattering layer is formed on the transparent substrate, a step (step S120) in which the light extraction assistance layer is provided on the scattering layer, a step (step S130) in which the first electrode is provided on the light extraction assistance layer, a step (step S140) in which the organic light emitting layer is provided on the first electrode, and a step (step S150) in which the second electrode is provided on the organic light emitting layer. Each of the steps is explained in detail in the following.

(Step S110)

First, the transparent substrate is prepared. As described above, the transparent substrate may be a glass substrate, a plastic substrate or the like.

Then, the scattering layer in which the scattering substances are dispersed in the glass base material is formed on the transparent substrate. The method of forming the scattering layer is not especially limited, but the method of forming the scattering layer by a "frit paste method" is specifically explained in this embodiment. However, the scattering layer may be formed by other methods.

In the frit paste method, a paste including a glass material, called a frit paste, is prepared (preparing step), the frit paste is coated at a surface of a substrate to be mounted and patterned (patterning step), and the frit paste is baked (baking step). With these steps, a desired glass film is formed on the substrate to be mounted. Each of the steps is explained in the following.

(Preparing step)

First, the frit paste including glass powders, resin, solvent and the like is prepared.

The glass powder is made of a material finally forming the base material of the scattering layer. The composition of the glass powder is not especially limited as long as desired scattering characteristics can be obtained while being capable of being in a form of the frit paste and baked. The composition of the glass powder may be, for example, including 20 mol % to 30 mol % of $P_2O_5$, 3 mol % to 14 mol % of $B_2O_3$, 10 mol % to 20 mol % of $Bi_2O_3$, 3 mol % to 15 mol % of $TiO_2$, 10 mol % to 20 mol % of $Nb_2O_5$, 5 mol % to 15 mol % of $WO_3$ where the total amount of $Li_2O$, $Na_2O$ and $K_2O$ is 10 to 20 mol %, and the total amount of the above components is more than or equal to 90 mol %. The grain diameter of the glass powder is, for example, within a range of 1 $\mu$m to 100 $\mu$m.

In order to control a thermal expansion characteristic of a finally obtained scattering layer, a predetermined amount of fillers may be added to the glass powder. As for the filler, for example, particles such as zircon, silica, alumina or the like may be used, and the grain diameter may be within a range of 0.1 $\mu$m to 20 $\mu$m.

For the resin, for example, ethyl cellulose, nitrocellulose, acrylic resin, vinyl acetate, butyral resin, melamine resin, alkyd resin, rosin resin or the like may be used. Ethyl cellulose, nitrocellulose or the like may be used as base resin. By adding butyral resin, melamine resin, alkyd resin, or rosin resin, the strength of the frit paste coating layer is improved.

The solvent has a function to dissolve resin and adjust the viscosity. The solvent may be, for example, an ether type solvent (butyl carbitol (BC), butyl carbitol acetate (BCA), diethylene glycol di-n-butyl ether, dipropylene glycol butyl ether, tripropylene glycol butyl ether, butyl cellosolve acetate), an alcohol type solvent ($\alpha$-terpineol, pine oil, Dowanol), an ester type solvent (2,2,4-trimethyl-1,3-pentanediol monoisobutyrate), a phthalic acid ester type solvent (dibutyl phthalate (DBP), dimethyl phthalate (DMP), dioctyl phthalate (DOP)) or the like. The solvent mainly used is $\alpha$-terpineol or 2,2,4-trimethyl-1,3-pentanediol monoisobutyrate. Further, dibutyl phthalate (DBP), dimethyl phthalate (DMP) and dioctyl phthalate (DOP) also function as a plasticizer.

Further, for the frit paste, a surfactant may be added for viscosity adjustment and frit dispersion promotion. Further, a silane coupling agent may be used for surface modification.

Then, the frit paste in which the glass materials are uniformly dispersed is prepared by mixing these materials.

(Patterning step)

Then, the frit paste prepared by the above described method is coated on the transparent substrate to be patterned. The method of coating and patterning is not especially limited. For example, the frit paste may be pattern printed on the transparent substrate using a screen printer. Alternatively, a doctor blade printing or a die coat printing may be used.

Thereafter, the frit paste layer is dried.

(Baking step)

Then, the frit paste layer is baked. Generally, baking is performed by two steps. In the first step, the resin in the frit paste layer is decomposed and made to disappear, and in the second step, the glass powders are baked and softened.

The first step is performed under the atmosphere by retaining the frit paste layer within a temperature range of 200 °C to 400 °C. Note that the process temperature is varied in accordance with the material of the resin included in the frit paste. For example, when the resin is ethyl cellulose, the process temperature may be about 350 °C to 400 °C and when the resin is nitrocellulose, the process temperature may be about 200 °C to 300 °C. The process period is generally about 30 minutes to 1 hour.

The second step is performed under the atmosphere by retaining the frit paste layer within a temperature range of softening temperature of the glass powder included in the frit paste layer $\pm$ 30 °C. The process temperature is, for example, within a range of 450 °C to 600 °C. Further, the process period is not especially limited, but for example, is 30 minutes to 1 hour.

The base material of the scattering layer is formed after the second step as the glass powder is baked and softened. Further, by the pores included in the frit paste layer, the scattering substances uniformly dispersed in the base material can be obtained.

Thereafter, by cooling the transparent substrate, the scattering layer having a surface whose side surface is moderately inclined with an angle smaller than a right angle is formed.

The thickness of the finally obtained scattering layer may be within a range of 5 $\mu$m to 50 $\mu$m.

(Step S120)

Then, the light extraction assistance layer is provided on the thus obtained scattering layer. The method of providing the light extraction assistance layer is not especially limited but a method of forming a film such as sputtering, vapor deposition, chemical vapor deposition or the like may be used, for example. Further, the light extraction assistance layer may be patterned.

(Step S130)

Then the first electrode (anode) is provided on the thus obtained light extraction assistance layer.

The method of providing the first electrode is not especially limited but a method of forming a film such as sputtering, vapor deposition, chemical vapor deposition or the like may be used, for example. Further, the first electrode may be patterned.

As described above, the material of the first electrode may be ITO or the like. Further, the thickness of the first electrode is not especially limited but may be within a range of 50 nm to 1.0 $\mu$m, for example.

The stacked structure including the transparent substrate, the scattering layer, the light extraction assistance layer and the first electrode obtained by the above described steps is referred to as a "translucent substrate". The specification of the organic light emitting layer that is to be provided in the next step varies in accordance with the applicable usage of the finally obtained organic EL element. Thus, customarily, there are many cases that the "translucent substrate" is distributed to a market as an intermediate product, and the following steps may be omitted.

(Step S140)

When manufacturing the organic EL element, the organic light emitting layer is provided to cover the first electrode. The method of providing the organic light emitting layer is not especially limited, but vapor deposition and/or coating may be used, for example.

(Step S150)

Then the second electrode is provided on the organic light emitting layer. The method of providing the second electrode is not especially limited but vapor deposition, sputtering, chemical vapor deposition or the like may be used, for example.

With the above methods, the organic EL element 100 as shown in Fig. 1 is manufactured.

Here, the above described method of manufacturing the organic EL element is an example and the organic EL element may be manufactured by other methods.

First example and second example of the embodiment are explained.

[First example]

Plural of the organic EL elements were manufactured by the following method.

(Formation of scattering layer)

A soda lime substrate having the length of 50 mm $\times$ the width of 50 mm $\times$ the thickness of 0.55 mm was prepared as the transparent substrate.

Then, materials for the scattering layer were prepared by the following method.

First, mixed particles having the composition shown in table 1 were prepared and were dissolved. The dissolution was performed by retaining the mixture at 1050 °C for 1.5 hours and then retaining the mixture at 950 °C for 30 minutes. Thereafter, the dissolved object was casted in a twin-roll process to obtain a flake glass.

[Table 1]

| MATERIAL | mol % |
|---|---|
| $P_2O_5$ | 22.7 |
| $B_2O_3$ | 11.8 |
| $Li_2O$ | 5.0 |
| $Bi_2O3$ | 14.9 |
| $Nb_2O_5$ | 15.7 |
| $WO_3$ | 9.3 |
| ZnO | 20.6 |

The glass transition temperature of the flake glass was measured by a thermal expansion method using thermal analysis equipment (trade name: TD5000SA, manufactured by Bruker). The temperature rising rate was 5 °C / minute. The glass transition temperature of the flake glass was 475 °C. Further, the thermal expansion coefficient of the flake glass was $72 \times 10^{-7}$ / °C.

The refraction index of the flake glass was measured using a refractometer (trade name: KRP-2, manufactured by Kalnew Optical Industrial Co., Ltd.). The refraction index "nd" of the flake glass was 1.98 at d-ray (587.56 nm).

Then, the flake glass was pulverized by a planetary ball mill made of zirconia for two hours to obtain a glass powder having a mean grain diameter ($d_{50}$: grain size at integrated value 50%, unit: $\mu$m) of 1 $\mu$m to 3 $\mu$m.

Next, 75 g of the glass powder and 25 g of an organic vehicle (prepared by dissolving about 10 mass % ethyl cellulose in α-terpineol or the like) were kneaded to prepare a glass paste. Further, the glass paste was printed on the soda lime substrate using a screen printer. With this, a scattering layer having two circular patterns each having a diameter of 10 mm was formed on the soda lime substrate. After the screen printing, the soda lime substrate was dried at 120 °C for ten minutes.

The screen printing and drying were repeated in order to thicken the scattering layer. The soda lime substrate was heated up to 450 °C in 45 minutes, retained for 10 hours at 450 °C, further heated to 575 °C in 12 minutes, retained for 40 minutes at 575 °C, and thereafter, cooled to the room temperature in three hours. With this operation, the scattering layer was formed on the soda lime substrate.

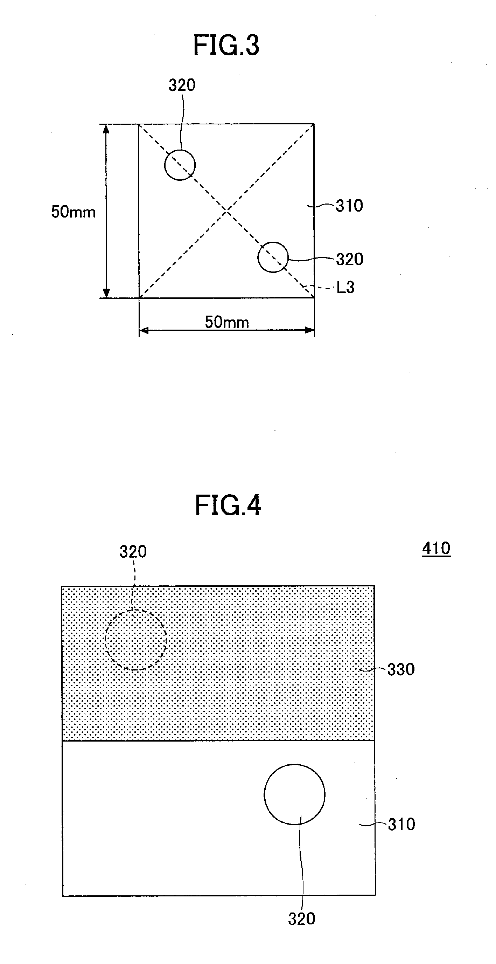

Fig. 3 is a schematic top view of the soda lime substrate having patterns of the scattering layer obtained by the above described steps. The patterns of the scattering layer formed on the soda lime substrate 310 include two scattering layers 320 and each of the scattering layers 320 has a circular shape with a diameter of 10 mm φ. The two scattering layers 320 were positioned such that distances from a center of the soda lime substrate 310 became the same along one of diagonal lines of the soda lime substrate 310. The thickness of the scattering layer 320 was about 42 $\mu$m.

Next, the total luminous transmittance and the haze value of the soda lime substrate 310 with the scattering layers 320 (referred to as a "scattering layer substrate" hereinafter) were measured. A haze meter HGM-2 manufactured by Suga Test Instruments Co., Ltd. was used as a measurement device. The total luminous transmittance and the haze value of the soda lime substrate (without the scattering layers 320) were also measured as a reference. As a result, the total luminous transmittance and the haze value of the scattering layer substrate were 69% and 73%, respectively.

Further, the surface waviness of the scattering layer was measured by a surfcom 1400D manufactured by TOKYO SEIMITSU CO., LTD. The arithmetic average of the surface roughness (Ra) of the scattering layer was 0.95 $\mu$m.

(Forming of light extraction assistance layer and first electrode)

Next, the light extraction assistance layer and the first electrode were formed on the scattering layer substrate manufactured as described above, by the following method.

First, a Ti 70 atomic%-Zr 30 atomic % target (target 1) and an ITO target (target 2) each having 6 inch diameter, were mounted at two cathodes of a batch magnetron sputtering device.

Next, the scattering layer substrate was mounted at a substrate holder of the device. At this time, a mask made of glass having a size 25 mm × 50 mm was mounted above the scattering layer substrate to cover a lower half part of the scattering layer substrate so that the layer is not deposited at the part.

After evacuating the sputtering device to be less than or equal to $1 \times 10^{-3}$ Pa, the substrate heater was set to be 250 °C. After the scattering layer substrate was heated, 25 sccm of argon gas and 25 sccm of oxygen gas were introduced as the atmospheric gas.

Then, the $TiZr_xO_y$ layer was formed at an upper half part of the scattering layer substrate, which was not masked, using the target 1 by the DC pulse sputtering with an input electric power of 1000 W as the light extraction assistance layer. The thickness of the $TiZr_xO_y$ layer was 40 nm.

Fig. 4 is a top view showing the soda lime substrate after the $TiZr_xO_y$ layer was formed. As shown in Fig. 4, the $TiZr_xO_y$ layer 330 was formed at the upper half part of the soda lime substrate 310. The soda lime substrate 310 is referred to as a "light extraction assistance layer substrate" 410 hereinafter. Here, for the explanation, the layers that exist lower than the topmost surface are expressed by dotted lines.

After the substrate heater was switched off, the sputtering device was opened to the atmosphere and the mask made of glass was exchanged for a mask for forming ITO. Thereafter, again, the sputtering device was evacuated to be less than or equal to $1 \times 10^{-3}$ Pa and the substrate heater was set to be 250 °C. After the light extraction assistance layer substrate 410 was heated, 98 sccm of argon gas and 2 sccm of oxygen gas were introduced as the atmospheric gas.

Next, the ITO layer was formed on the light extraction assistance layer substrate 410 using the target 2 by the DC pulse sputtering with an input electric power of 300 W. Thereafter, the substrate heater was switched off, the sputtering device was opened to the atmosphere, and the light extraction assistance layer substrate 410 on which the ITO layer was formed was extracted. The thickness of the ITO layer was 150 nm.

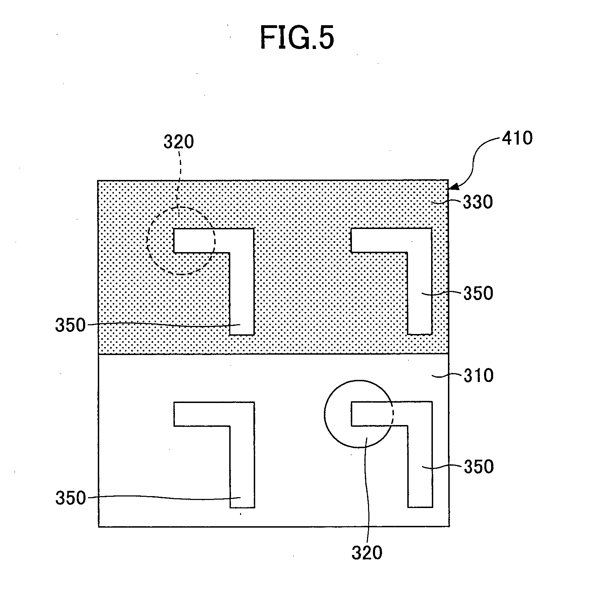

Fig. 5 is a top view showing the light extraction assistance layer substrate 410 after the ITO layer is formed. As shown in Fig. 5, each of the ITO layers 350 was formed to have a pattern like a rotated character "L" about 180°. Further, in Fig. 5, the ITO layer 350 at the left and upper part and the ITO layer 350 at the right and lower part are positioned such that a part (near an end portion) in a lateral direction of the respective ITO layer 350 is positioned to overlap a center of the scattering layer 320, respectively.

Hereinafter, the light extraction assistance layer substrate 410 on which the ITO layer is formed shown in Fig. 5 is referred to as a "translucent substrate".

In addition to above, the refraction index of the $TiZr_xO_y$ layer was measured by the following method.

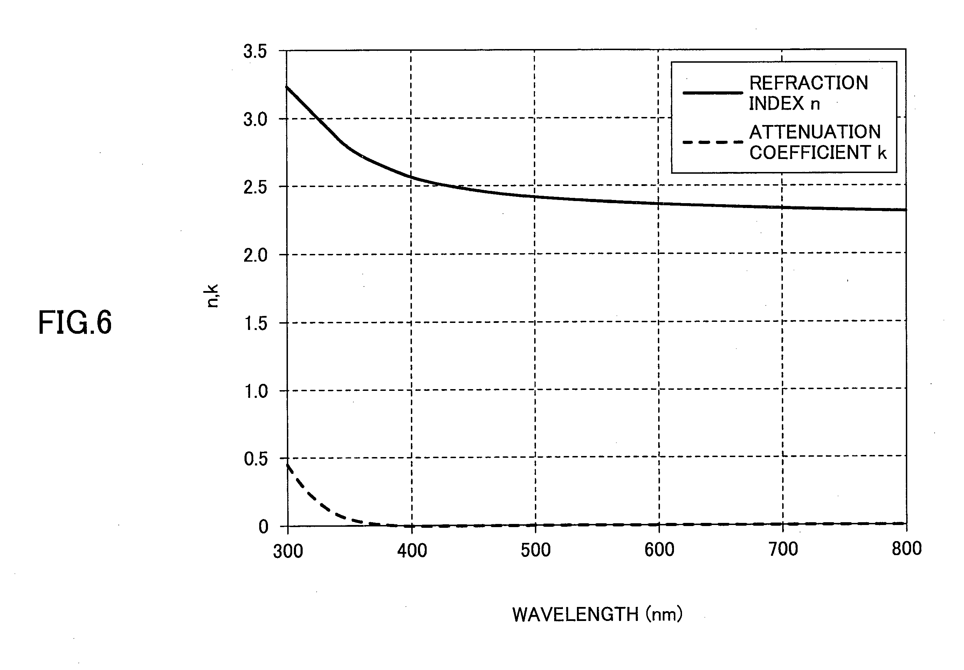

As a measuring sample, the $TiZr_xO_y$ layer was used that was directly formed on the above soda lime substrate by the sputtering condition as described above. The thickness of the $TiZr_xO_y$ layer was 40 nm. The refraction index of the sample was measured by a spectroscopic ellipsometry M-2000 manufactured by J. A. Woollam Co., Inc. Fig. 6 shows the result.

It can be understood from Fig. 6 that the refraction index of the $TiZr_xO_y$ layer is more than or equal to 2.4 within a wavelength range of 430 nm to 650 nm.

(Manufacturing of organic EL element)

Next, an organic EL element was manufactured using the translucent substrate formed as described above.

First, ultrasonic washing was performed using pure water and IPA, and thereafter, oxygen plasma was irradiated on the translucent substrate to clean the surface.

Next, 100 nm of $\alpha$-NPD (N,N'-diphenyl-N,N'-bis(1-naphthyl)-1,1'biphenyl-4,4"diamine), 60 nm of $Alq_3$ (tris8-hydroxyquinoline aluminum), 0.5 nm of LiF and 80 nm of Al were continuously deposited on the translucent substrate using a vacuum vapor deposition apparatus.

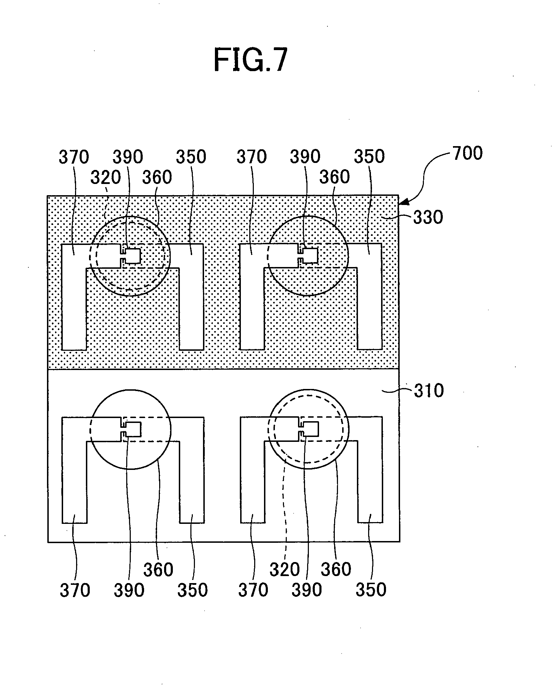

Fig. 7 is a top view showing the translucent substrate 700 after the films are formed.

As shown in Fig. 7, a layer 360 of $\alpha$-NPD and $Alq_3$ was patterned to be four circular patterns each having a diameter of 12 mm on the translucent substrate 700. Each of the four circular patterns of the layer 360 of $\alpha$-NPD and $Alq_3$ was formed to cover the front edge of the respective ITO layer 350 in the lateral direction.

A layer 370 of LiF and Al was formed to be four patterns each being mirror symmetrical with respect to the respective ITO layer 350 using a mask on the translucent substrate 700. Each of the patterns of the layer 370 of LiF and A1 was formed to have a region having an area 2 x 2 mm at the front edge in the lateral direction. Each of the regions 390 was formed to overlap the center of the respective layer 360 of $\alpha$-NPD and $Alq_3$.

With this, when seen from the top, a sample including four organic EL elements where the regions 390 are light emitting units was obtained.

Thereafter, the sample was divided into four pieces of 25 x 25 mm. With this, (1) the organic EL element (see the left and upper piece of Fig. 7) (referred to as sample A1) in which the scattering layer 320, the light extraction assistance layer 330, the ITO layer 350, the organic light emitting layer ($\alpha$-NPD, $Alq_3$ and LiF) and the A1 layer were provided on the soda lime substrate 310, (2) the organic EL element (see the right and upper piece of Fig. 7) (referred to as sample A2) in which the light extraction assistance layer 330, the ITO layer 350, the organic light emitting layer ($\alpha$-NPD, $Alq_3$ and LiF) and the Al layer were formed on the soda lime substrate 310, (3) the organic EL element (see the left and lower piece of Fig. 7) (referred to as sample A3) in which the ITO layer 350, the organic light emitting layer ($\alpha$-NPD, $Alq_3$ and LiF) and the A1 layer were formed on the soda lime substrate 310, and (4) the organic EL element (see the right and lower piece of Fig. 7) (referred to as sample A4) in which the scattering layer 320, the ITO layer 350, the organic light emitting layer ($\alpha$-NPD, $Alq_3$ and LiF) and the Al layer were formed on the soda lime substrate 310, were manufactured.

If the organic EL elements are left in the atmosphere, the organic EL elements may be deteriorated by the water in the atmosphere. Thus, the samples A1 to A4 were plastic sealed by the following method.

First, a concave portion is provided at a center portion of a separately provided glass substrate (opposing substrate) by sand blasting.

Then, a water capturing agent including CaO was attached in the concave portion. Then, the samples A1 to A4 were respectively placed on the concave portion of the opposing substrate with the soda lime substrate being positioned above. Then, photosensitive epoxy resin was coated at an area of the opposing substrate surrounding the concave portion such that a space with the respective sample was filled. Finally, ultraviolet rays were irradiated on the photosensitive epoxy resin to cure the resin and seal the samples, respectively.

(Reference example 1)

Similar to the first example, (1) the organic EL element (referred to as sample B1) in which the scattering layer 320, the light extraction assistance layer 330, the ITO layer 350, the organic light emitting layer and the A1 layer were provided on the soda lime substrate 310, (2) the organic EL element (referred to as sample B2) in which the light extraction assistance layer 330, the ITO layer 350, the organic light emitting layer and the Al layer were provided on the soda lime substrate 310, (3) the organic EL element (referred to as sample B3) in which the ITO layer 350, the organic light emitting layer and the Al layer were provided on the soda lime substrate 310 and (4) the organic EL element (referred to as sample B4) in which the scattering layer 320, the ITO layer 350, the organic light emitting layer and the A1 layer were provided on the soda lime substrate 310 were manufactured.

Here, in the reference example 1, a $SiO_2$ layer (thickness of 40 nm) was provided instead of the $TiZr_xO_y$ layer as the light extraction assistance layer 330.

It means that in the reference example 1, the light extraction assistance layer 330 was deposited using a Si target (target 3) having 6 inch diameter instead of the Ti 70 atomic%-Zr 30 atomic % target (target 1) having a 6 inch diameter. For the atmospheric gas when depositing, 25 sccm of argon gas and 25 sccm of oxygen gas were introduced. The input electric power of the DC pulse sputtering was set to be 300 W.

Other manufacturing conditions were the same as those of the first example.

(Evaluation of optical characteristics of samples)

The evaluation of the optical characteristics such as current-voltage characteristics or the like using the samples A1 to A4 and B1 to B4 was performed.

For evaluating the current-voltage characteristics, an EL characteristics measurement device C9920-12 manufactured by Hamamatsu Photonics K. K. was used.

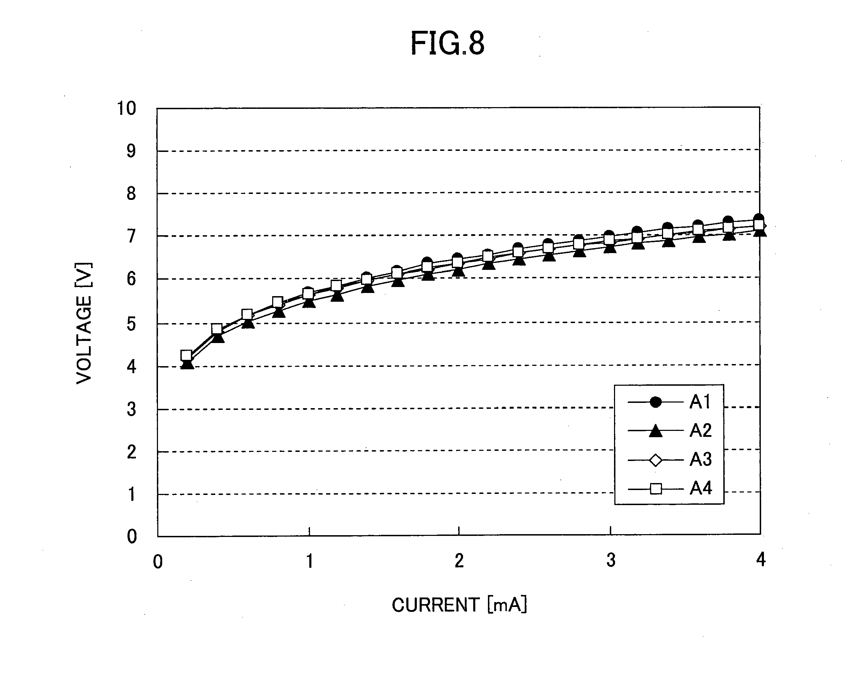

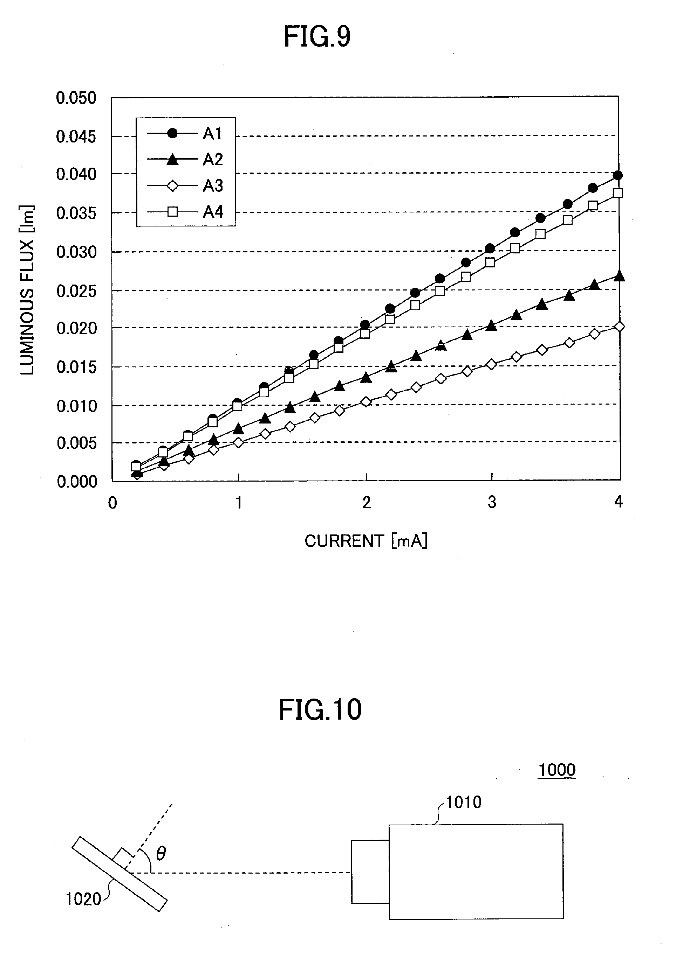

Fig. 8 is a view showing current-voltage characteristics of the organic EL elements obtained as the samples A1 to A4. Fig. 9 is a view showing current-luminous flux characteristics.

From the result shown in Fig. 8, it can be understood that all of the samples A1 to A4 appropriately function as the organic EL elements. From the result shown in Fig. 9, the luminous flux (1m) were further improved from the sample A3 (without the scattering layer, without the light extraction assistance layer), the sample A2 (without the scattering layer, with the light extraction assistance layer), the sample A4 (with the scattering layer, without the light extraction assistance layer) to the sample A1 (with the scattering layer and with the light extraction assistance layer) in this order.

In table 2, values of luminous flux at the current value of 4 mA for each of the samples A1 to A4 are shown. In this table, magnifications of the luminous flux of the samples A1, A2 and A4 with respect to that of the sample A3, which is set as reference (1), are shown.

[Table 2]

| SAMPLE | SCATTERING LAYER | LIGHT EXTRACTION ASSISTANCE LAYER | LUMINOUS FLUX AT 4 mA (lm) | MAGNIFICATION |
|--------|------------------|-----------------------------------|----------------------------|---------------|
| A1 | WITH | WITH | 0.0397 | 1.99 |
| A2 | WITHOUT | WITH | 0.0267 | 1.34 |
| A3 | WITHOUT | WITHOUT | 0.0200 | 1 |
| A4 | WITH | WITHOUT | 0.0373 | 1.87 |

From table 2, the magnification of the luminous flux of the sample A1 (with the scattering layer, with the light extraction assistance layer) reaches 1.99 and it can be understood that it is significantly improved compared with the case of the sample A4 (with the scattering layer, without the light extraction assistance layer).

Next, the angular dependency of the light emission and the chromaticity for the samples A1 to A4 were evaluated.

Fig. 10 is a schematic view showing an example of a structure of a measurement device.

As shown in Fig. 10, a measurement device 1000 includes a lightmeter 1010 and a sample 1020. As the lightmeter 1010, a color lightmeter (trade name: BM-7A) manufactured by Topcon Technohouse Corporation was used.

The measurement was conducted as follows.

First, by flowing a current of 1 mA through both the electrodes, the sample 1020 emitted light. Next, the sample 1020 was rotated with respect to the lightmeter 1010, and the light emission at each angle θ (°) was measured by the lightmeter 1010.

As shown in Fig. 10, the angle θ is an angle between a normal direction of the sample 1020 and a direction from the sample 1020 toward the lightmeter 1010. Thus, θ = 0° at a state where the lightmeter 1010 is positioned in front of the sample 1020.

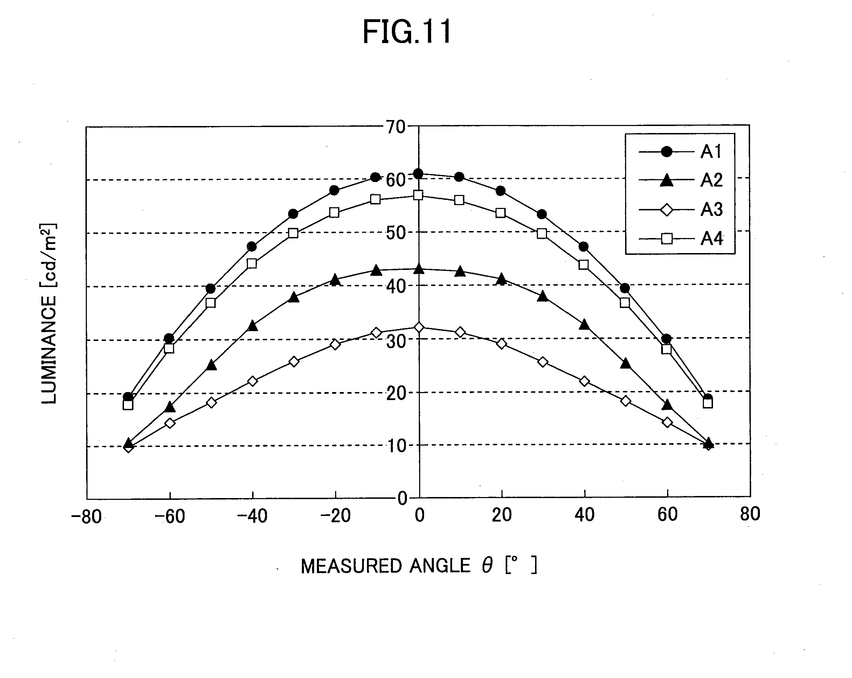

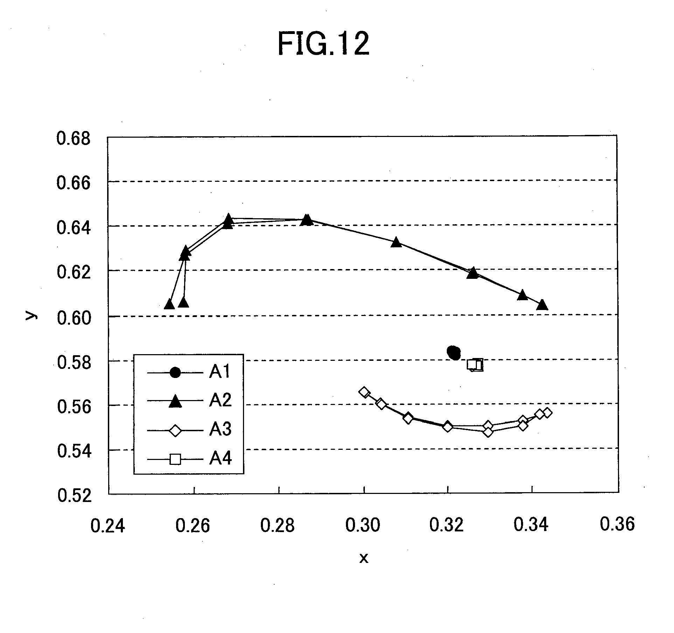

Fig. 11 and Fig. 12 show the measurement results. Fig. 11 shows the luminance in accordance with the angle variation and Fig. 12 shows the chromaticity in accordance with the angle variation. Here, a CIE1976UCS color system was used for calculation of the chromaticity coordinate.

It can be understood From Fig. 11 that the luminance was more improved from the sample A3, the sample A2, the sample A4 and the sample A1 in this order regardless of the measured angle. Further, it can be understood that the luminance of the sample A1 is much higher than that of the sample A3 at all of the measured angles. This corresponds to the tendency of the above described measured result of the current and luminous flux.

Further, it can be understood from Fig. 12 that the variation of the chromaticity by the measured angle is suppressed for the sample A1 compared with that of the sample A3. This result suggests that the limitation of a view angle is moderated for the sample A1.

As described above, by composing the organic EL element with the structure of the sample A1, it can be expected that the optical characteristics of the organic EL element are significantly improved.

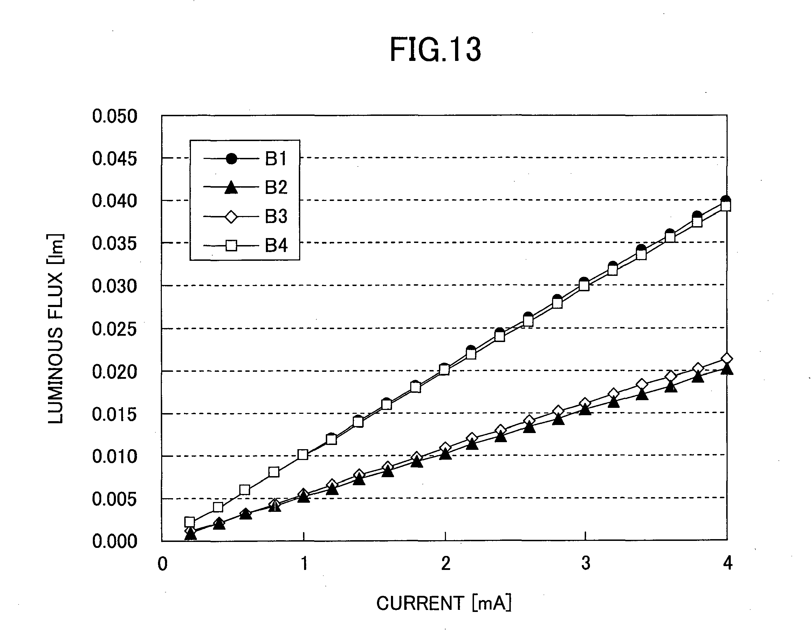

Fig. 13 is a view showing current-luminous flux characteristics obtained for the samples B1 to B4.

It can be understood from the result shown in Fig. 13 that the luminous flux (lm) is low for the sample B2 (without the scattering layer, with the light extraction assistance layer) and the sample B3 (without the scattering layer, without the light extraction assistance layer) at almost the same level, and is high for the sample B4 (with the scattering layer, without the light extraction assistance layer) and the sample B1 (with the scattering layer, with the light extraction assistance layer) at almost the same level.

In table 3, values of luminous flux at the current value of 4 mA for each of the samples B1 to B4 are shown. In this table, magnifications of the luminous flux of the samples B1, B2, and B4 with respect to that of the sample B3, which is set as reference (1), are shown.

[Table 3]

| SAMPLE | SCATTERING LAYER | LIGHT EXTRACTION ASSISTANCE LAYER | LUMINOUS FLUX AT 4 mA (lm) | MAGNIFICATION |
|---|---|---|---|---|
| B1 | WITH | WITH | 0.0398 | 1.86 |
| B2 | WITHOUT | WITH | 0.0202 | 0.95 |
| B3 | WITHOUT | WITHOUT | 0.0214 | 1 |
| B4 | WITH | WITHOUT | 0.0391 | 1.83 |

With this table, it can be understood that the magnification of the luminous flux of the sample B1 (with the scattering layer, with the light extraction assistance layer) is 1.86, which is almost the same level as that of the sample B4 (with the scattering layer, without the light extraction assistance layer).

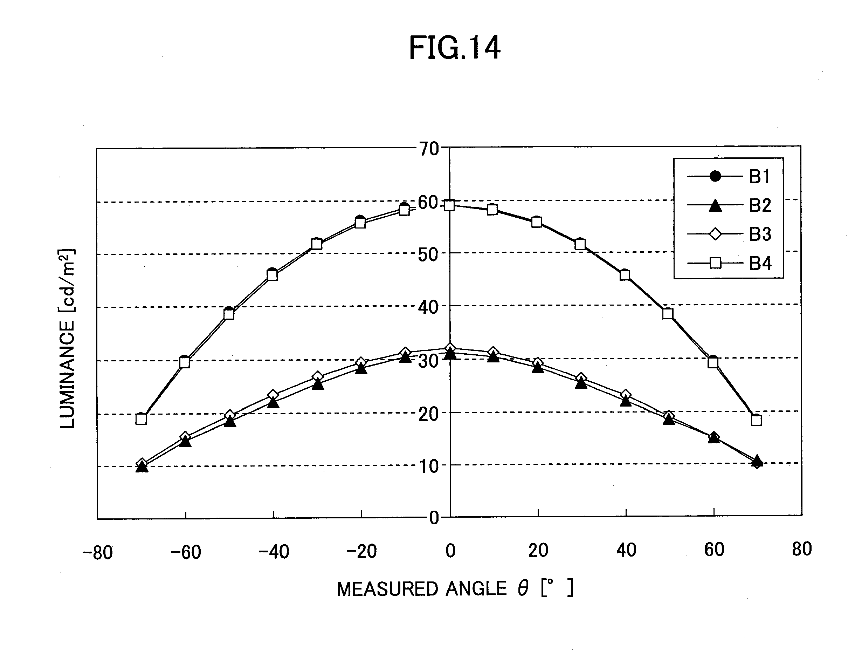

Fig. 14 shows the measured result of the angular dependency of the luminance obtained for the samples B1 to B4.

For the case of the samples B1 to B4, regardless of the measuring angles, the luminance becomes lower for the sample B2 and the sample B3 and improves for the sample B4 and the sample B1. It means that the luminance of the sample B1 is the same as that of the sample B4 and the effect of the light extraction assistance layer cannot be obtained.

As described above, it is confirmed that when the $TiZr_xO_y$ layer is used as the light extraction assistance layer, the optical characteristics of the organic EL element are significantly improved. However, it is confirmed that when the $SiO_2$ layer is used as the light extraction assistance layer, the optical characteristics of the organic EL element are not improved.

[Second example]

When the light extraction assistance layer is not included in the organic EL element, the difference between the refraction indexes of the first electrode and the scattering layer becomes small so that the reflectance at an interface between the first electrode and the scattering layer becomes small. As a result, even when the thickness of the first electrode and/or the organic light emitting layer, for example, of the organic EL element is varied, the interference condition of the organic EL element does not vary a lot.

On the other hand, for the structure in which the light extraction assistance layer is provided between the scattering layer and the first electrode and the refraction index of the light extraction assistance layer is far different from those of the scattering layer and the first electrode, the reflectance at the interface between the scattering layer and the light extraction assistance layer and the interface between the light extraction assistance layer and the first electrode increase and the interference condition can be controlled by the thickness variation of the light extraction assistance layer and the organic light emitting layer. Further, with this, the incident angle of the light generated in the organic light emitting layer toward the scattering layer can be changed and, as a result, the light extracting efficiency can be improved.

Based on the above consideration, in order to optimize the interference condition of the light of the organic EL element, interference calculation was performed. For the interference calculation software, Setfos manufactured by CYBERNET SYSTEMS CO., LTD. was used.

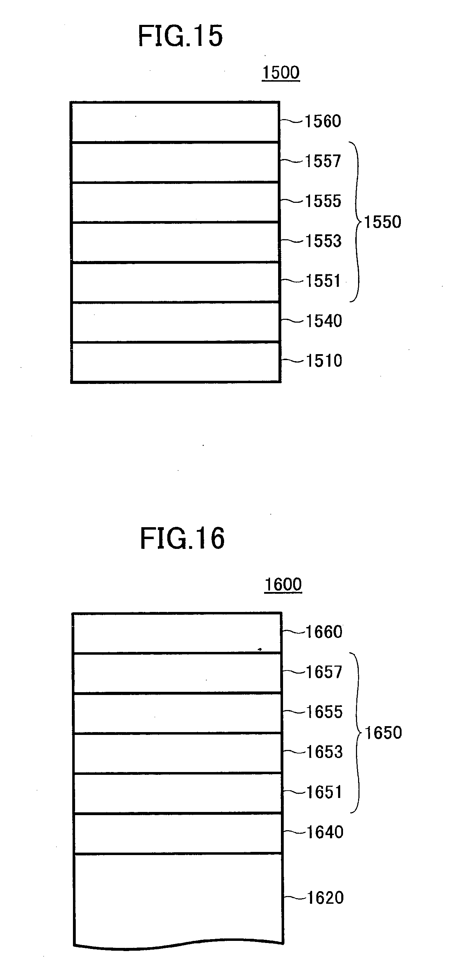

Fig. 15 to Fig. 17 show structures of organic EL elements used in the calculation.

In Fig. 15, the structure of an organic EL element that is used as a basic of the calculation is shown and in this structure, the scattering layer and the light extraction assistance layer do not exist. It means that the organic EL element 1500 shown in Fig. 15 is formed by stacking a glass substrate 1510, a first electrode (transparent electrode) 1540, an organic light emitting layer 1550 and a second electrode (reflection electrode) 1560 in this order. The organic light emitting layer 1550 is formed by stacking, from a side near to the first electrode 1540, a hole transport layer 1551, a light emitting layer 1553, an electron transport layer 1555 and an electron injection layer 1557 in this order.

Further, the organic EL element 1600 shown in Fig. 16 is formed by stacking a scattering layer matrix glass 1620, a first electrode (transparent electrode) 1640, an organic light emitting layer 1650 and a second electrode (reflection electrode) 1660 in this order. The organic light emitting layer 1650 is formed by stacking, from a side near to the first electrode 1640, a hole transport layer 1651, a light emitting layer 1653, an electron transport layer 1655 and an electron injection layer 1657 in this order.

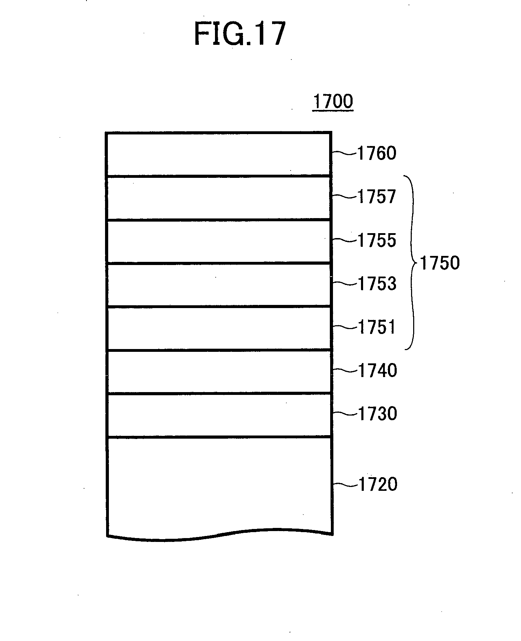

Further, the organic EL element 1700 shown in Fig. 17 is formed by stacking a scattering layer matrix glass 1720, a light extraction assistance layer 1730, a first electrode (transparent electrode) 1740, an organic light emitting layer 1750 and a second electrode (reflection electrode) 1760 in this order. The organic light emitting layer 1750 is formed by stacking, from a side near to the first electrode 1740, a hole transport layer 1751, a light emitting layer 1753, an electron transport layer 1755 and an electron injection layer 1757 in this order.

It was assumed that the glass substrate 1510 of Fig. 15 is a soda lime glass. Further, it was assumed that the scattering layer matrix glasses 1620 and 1720 of Fig. 16 and Fig. 17, respectively, are the composition shown in table 4.

[Table 4]

| COMPONENT | mol % |
|---|---|
| $P_2O_5$ | 23.9 |
| $B_2O_3$ | 12.4 |
| $Li_2O$ | 5.2 |
| $Bi_2O_3$ | 15.6 |
| $Nb_2O_5$ | 16.4 |
| ZnO | 21.6 |
| $ZrO_2$ | 4.9 |

The first electrodes 1540, 1640 and 1740 were ITO and the second electrodes 1560, 1660, and 1760 were A1, respectively.

For the organic light emitting layers 1550, 1650 and 1750, the hole transport layers 1551, 1651 and 1751 were $\alpha$-NPD, the light emitting layers 1553, 1653 and 1753 were layers of $Alq_3$ in each of which 2 weight % of DCJTB (4-(Dicyanomethylene)-2-tert-butyl-6-(1,1,7,7-tetramethyljulolidin-4-yl-vinyl)-4H-pyran) was doped, the electron transport layers 1555, 1655 and 1755 were $Alq_3$, and the electron injection layers 1557, 1657 and 1757 were LiF, respectively.

Further, it is assumed that the light extraction assistance layer 1730 was the $Ti_xZr_yO$ layer (hereinafter, simply referred to as a "TZO layer").

In table 5, the refraction index "n" and the attenuation coefficient "k" of each of the layers are shown. In table 5, the expression "9.1E-07" of the scattering layer matrix glass at wavelength 435.8 nm indicates $9.1 \times 10^{-7}$.

[Table 5]

| LAYER | | WAVELENGTH (nm) | | | |
|---|---|---|---|---|---|
| | | 435.8 | 486.1 | 587.6 | 656.3 |
| GLASS SUBSTRATE | n | 1.528 | 1.523 | 1.517 | 1.515 |
| | k | 0.0E+00 | 0.0E+00 | 0.0E+00 | 0.0E+00 |
| SCATTERING LAYER MATRIX GLASS | n | 1.993 | 1.968 | 1.938 | 1.927 |
| | k | 9.1E-07 | 7.6E-08 | 1.7E-09 | 2.6E-10 |
| TZO LAYER | n | 2.464 | 2.406 | 2.344 | 2.321 |
| | k | 3.7E-04 | 3.9E-05 | 7.6E-07 | 8.6E-08 |
| FIRST ELECTRODE (BOTTOM PORTION) | n | 2.086 | 2.042 | 1.962 | 1.909 |
| | k | 1.5E-02 | 1.5E-02 | 1.8E-02 | 2.2E-02 |
| FIRST ELECTRODE (UPPER PORTION) | n | 2.108 | 2.065 | 2 | 1.965 |
| | k | 4.0E-03 | 5.7E-03 | 1.0E-02 | 1.5E-02 |

(continued)

| LAYER | | WAVELENGTH (nm) | | | |
|---|---|---|---|---|---|
| | | 435.8 | 486.1 | 587.6 | 656.3 |
| HOLE TRANSPORT LAYER | n | 1.962 | 1.886 | 1.808 | 1.782 |
| | k | 1.3E-04 | 3.4E-08 | 1.6E-13 | 3.6E-16 |
| LIGHT EMITTING LAYER | n | 1.777 | 1.698 | 1.682 | 1.661 |
| | k | 2.4E-02 | 2.3E-03 | 3.2E-03 | 0.0E+00 |
| ELECTRON TRANSPORT LAYER | n | 1.857 | 1.766 | 1.712 | 1.696 |
| | k | 5.1 E-02 | 0.0E+00 | 1.4E-03 | 1.7E-03 |
| ELECTRON INJECTION LAYER | n | 1.397 | 1.395 | 1.392 | 1.391 |
| | k | 0.0E+00 | 0.0E+00 | 0.0E+00 | 0.0E+00 |
| SECOND ELECTRODE | n | 0.808 | 1.098 | 1.606 | 2.023 |
| | k | 6.1E+00 | 6.8E+00 | 7.9E+00 | 8.8E+00 |

Each of the first electrodes 1540, 1640 and 1740 includes two layers the refraction indexes of which are different from each other. Thus, when calculating, for the index of each of the first electrodes 1540, 1640 and 1740, the value described in the first electrode (upper portion) in table 5 was used for the refraction index of the upper half and the value described in the first electrode (bottom portion) in table 5 was used for the refraction index of the lower half, respectively.

It is impossible for the calculation software "Setfos" to calculate the scattering phenomenon in the scattering layer although it is possible to perform the interference calculation. Thus, in this embodiment, the luminance of the light that exits in a direction perpendicular with respect to the glass substrate or the scattering layer matrix glass was calculated by interference calculation.

Actually, as the light injected into the scattering layer is scattered or reflected at the interface between the scattering layer and the glass substrate, the luminance of the light extracted in the perpendicular direction from the glass substrate and the luminance of the light injected into the scattering layer in the perpendicular direction do not match. However, it can be considered that when the luminance of the light injected into the scattering layer in the perpendicular direction is high, the luminance of the light finally ejected toward the atmosphere from the substrate in the perpendicular direction becomes high as well.

When the organic EL element is formed on the glass substrate with the scattering layer having a higher refraction index, the angular dependency of the ejected light corresponds to $\cos\theta$ rule. Thus, it can be estimated that when the luminance of the light ejected from the glass substrate in the perpendicular direction is high, the luminous flux of the total ejected light is also large.

Next, actual calculation results are described.

For the organic EL elements 1500 and 1600 shown in Fig. 15 and Fig. 16, the thickness of the hole transport layers 1551 and 1651 were varied, respectively. For the organic EL element 1700 shown in Fig. 17, the thicknesses of the hole transport layer 1751 and the TZO layer 1730 were varied.

The thicknesses of the other layers were kept constant. It means that the thickness of each of the first electrodes 1540, 1640 and 1740 (the total of the two layers) was 150 nm, the thickness of each of the light emitting layers 1553, 1653 and 1753 was 20 nm, the thickness of each of the electron transport layers 1555, 1655 and 1755 was 70 nm, the thickness of each of the electron injection layers 1557, 1657 and 1757 was 0.5 nm, and the thickness of each of the second electrodes 1560, 1660 and 1760 was 80 nm.

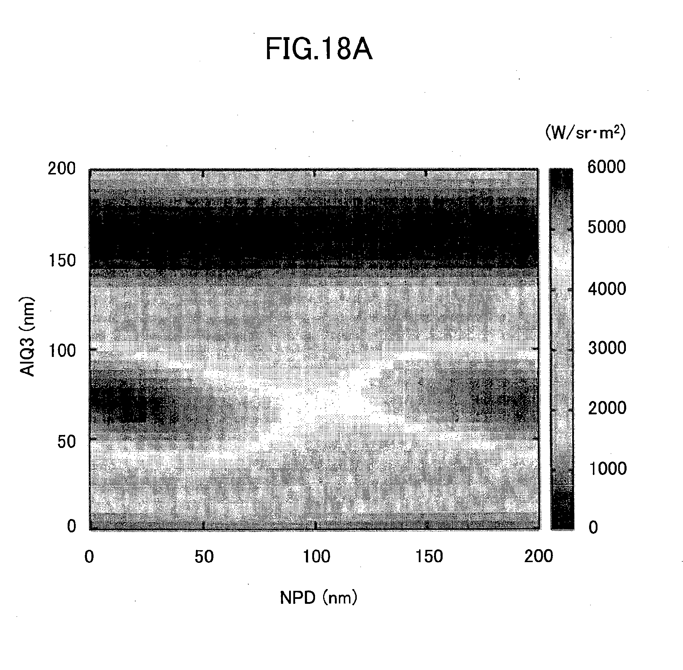

The calculation results are shown in Fig. 18A to Fig. 20B.

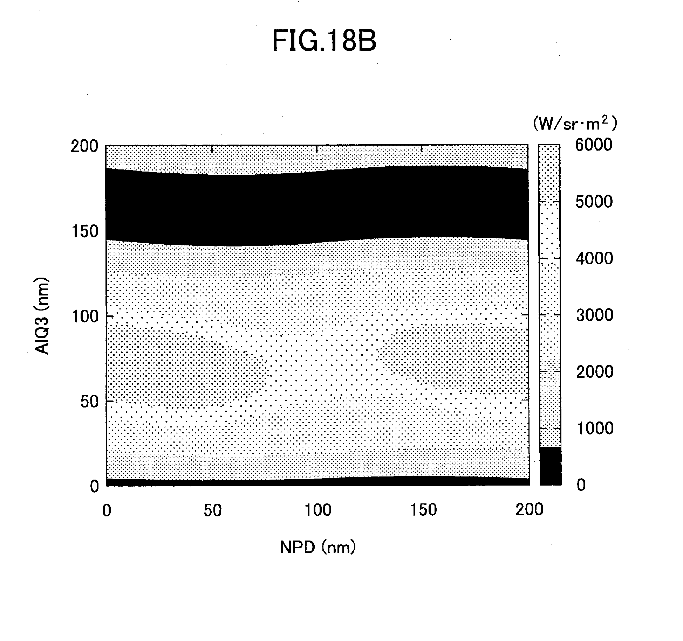

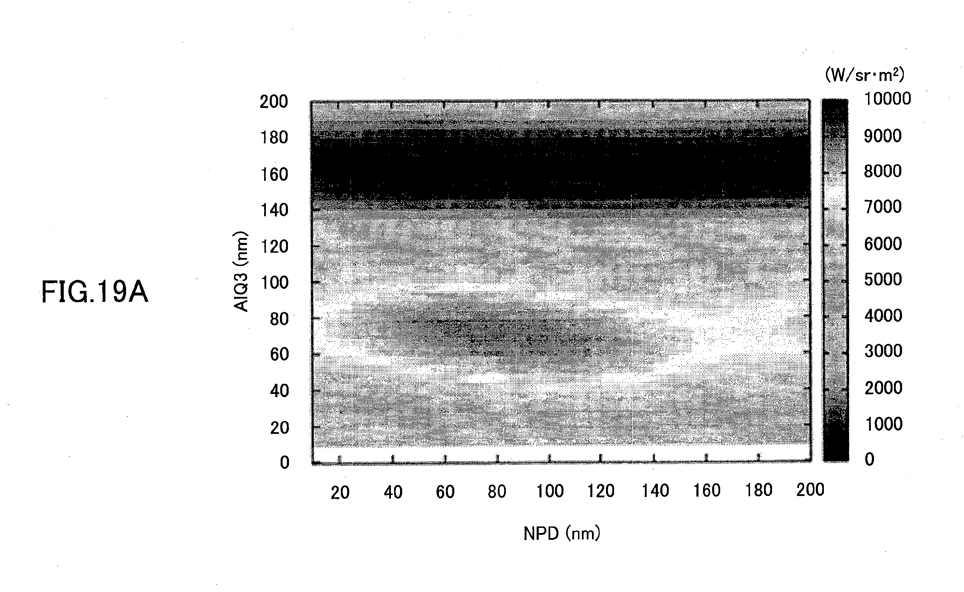

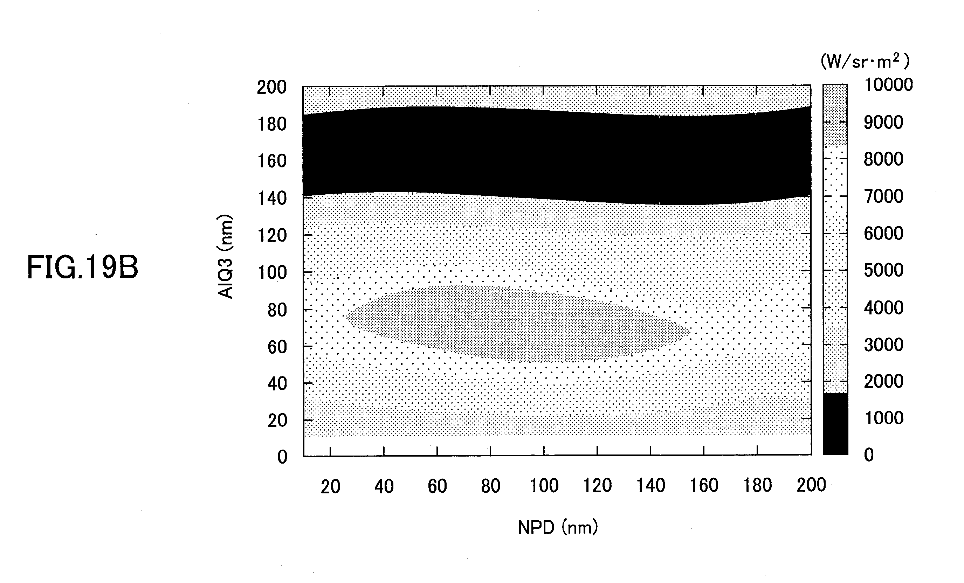

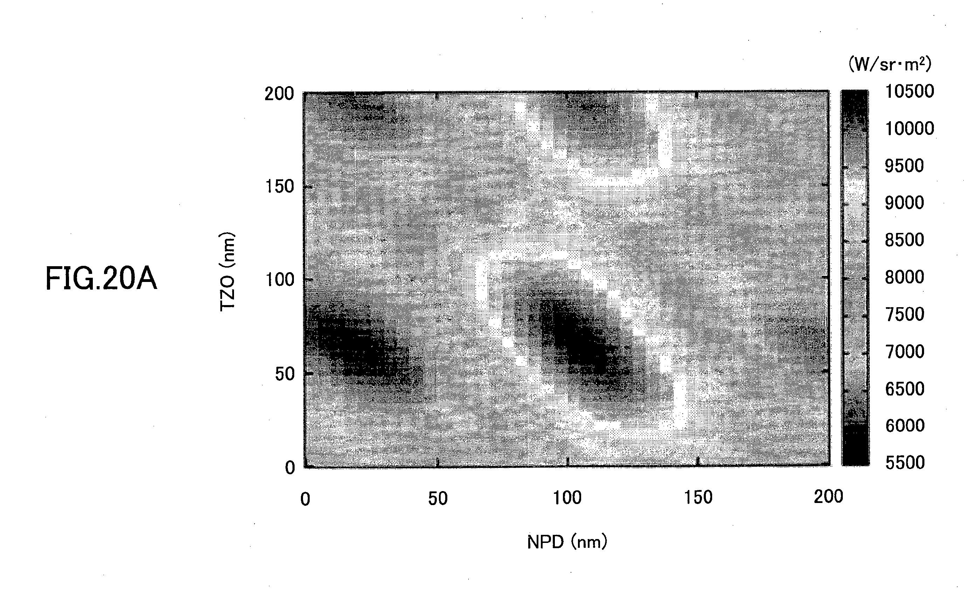

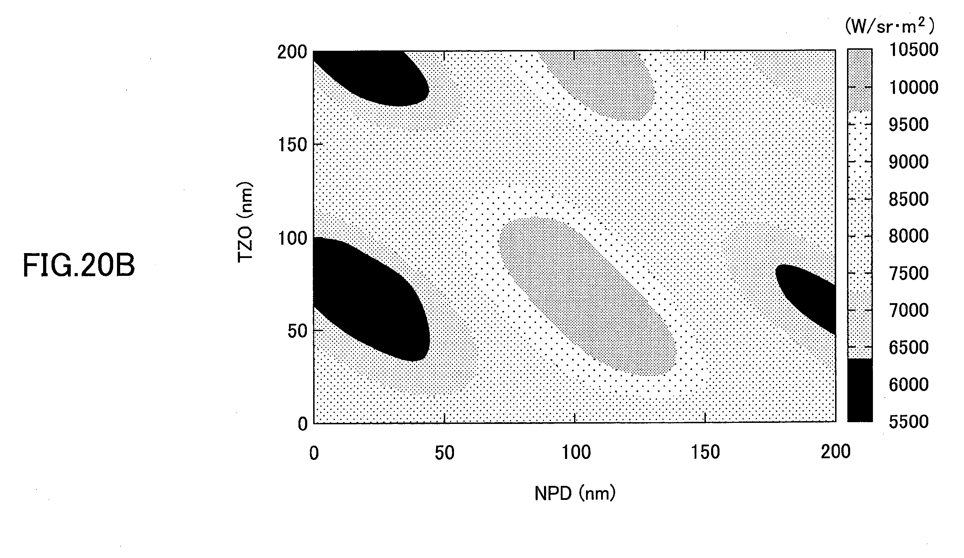

In Figs. 18A and 18B, frontal luminance (Radiance) of the organic EL element 1500 shown in Fig. 15, which is the basic structure, is shown. In Fig. 19A and Fig. 19B, and Fig. 20A and Fig. 20B, frontal luminance (Radiance) of the organic EL elements 1600 and 1700 shown in Fig. 16 and Fig. 17 are shown, respectively. As described above, in Fig. 18A to Fig. 20B, $AlQ_3$ indicates quinolinol aluminum complex, NPD indicates N,N'-Bis(1-naphthyl)-N,N'-Diphenyl-1,1'-biphenyl-4,4'-diamine, and TZO indicates $Ti_xZr_yO$.

In table 6, the optimum thicknesses of the layers that were varied are shown with the thicknesses of the layers that were fixed, of the organic EL elements 1500, 1600 and 1700.

[Table 6]

| | TZO LAYER | FIRST ELECTRODE | HOLE TRANSPORT LAYER | LIGHT EMITTING LAYER | ELECTRON TRANSPORT LAYER | ELECTRON INJECTION LAYER | SECOND ELECTRODE |
|---|---|---|---|---|---|---|---|
| ORGANIC EL ELEMENT 1500 | - | 150 | 15 | 20 | 70 | 0.5 | 80 |
| ORGANIC EL ELEMENT 1600 | - | 150 | 85 | 20 | 70 | 0.5 | 80 |
| ORGANIC EL ELEMENT 1700 | 70 | 150 | 90 | 20 | 70 | 0.5 | 80 |
| THICKNESS (nm) | | | | | | | |

Although the thickness of the electron transport layer 1755 was fixed at 70 nm in Figs. 20A and 20B, it is understood that even when the thickness of the electron transport layer 1755 was varied, the maximum value of the luminance was obtained when the thickness of the electron transport layer 1755 was 70 nm.

(Manufacturing of organic EL element)

Next, three kinds of structures of organic EL elements capable of providing the optimum light extracting efficiency by the above described calculation result were actually manufactured and the characteristics thereof were evaluated.
The organic EL elements were manufactured by the following method.

(Forming of scattering layer)

A soda lime substrate of the length 50 mm × the width 50 mm × the thickness 0.55 mm was prepared as a glass substrate.
Source materials of the scattering layer were prepared as follows.
First, mixed particles having the composition shown in table 4 were prepared. The mixed particles were retained at 1250 °C for 1.5 hours to be dissolved and the dissolved object was casted in the twin-roll process to obtain a flake glass.
The glass transition temperature of the flake glass was measured by the thermal expansion method using a thermal analysis equipment (trade name: TD5000SA, manufactured by Bruker). The temperature rising rate was 5 °C / minute. The glass transition temperature of the flake glass was 490 °C. Further, the thermal expansion coefficient of the flake glass was $70 \times 10^{-7}$ / °C.
The refraction index of the flake glass was measured using a refractometer (trade name: KRP-2, manufactured by Kalnew Optical Industrial Co., Ltd.). The refraction index of the flake glass was 1.94 at d-ray (587.56 nm).
Next, the flake glass was pulverized by the planetary ball mill made of zirconia for two hours to obtain a glass powder having a mean grain diameter ($d_{50}$: grain size at integrated value 50%, unit: $\mu$m) of 1 $\mu$m to 3 $\mu$m. Next, 75g of the glass powder was kneaded with 25g of the organic vehicle (prepared by dissolving about 10 mass % ethyl cellulose in $\alpha$-terpineol or the like) to prepare a glass paste. Further, using the screen printer, the glass paste was printed on the soda lime substrate. With this, a scattering layer having two circular patterns each having a diameter of 10 mm $\varphi$ was formed on the soda lime substrate.
After the screen printing, the soda lime substrate was dried at 120 °C for 10 minutes. In order to thicken the scattering layer, the screen printing of the glass paste and the drying were repeated. The soda lime substrate was heated to be 450 °C in 45 minutes, left at 450 °C for 10 hours, heated to 575 °C in 12 minutes, retained at 585 °C for 40 minutes, and cooled to room temperature in three hours. With this, the scattering layer was formed on the soda lime substrate.
The patterns of the scattering layer were the same as those shown in Fig. 3. The thickness of the scattering layer after being baked was 45 $\mu$m.
Similar to the first example, the total luminous transmittance and the haze value of the soda lime substrate with the scattering layer were measured. The haze meter HGM-2 manufactured by Suga Test Instruments Co.,Ltd. was used as the measurement device. The total luminous transmittance and the haze value of the soda lime substrate without the scattering layer were also measured as a reference. As a result, the total luminous transmittance and the haze value of the soda lime substrate at the part where the scattering layer was provided were 83% and 83%, respectively.
Further, the surface waviness of the scattering layer was measured by the surfcom 1400d manufactured by TOKYO SEIMITSU CO., LTD. The arithmetic average of the surface roughness (Ra) of the scattering layer was 0.11 $\mu$m.
As described above, the soda lime substrate (hereinafter, referred to as a "scattering layer substrate") having two patterns of the scattering layer at the surface was manufactured.

(Forming of light extraction assistance layer)

Next, a light extraction assistance layer was formed on the scattering layer substrate manufactured as described above, by the following method.
First, the Ti 70 atomic%-Zr 30 atomic % target (target 1) and the ITO target (target 2) each having 6 inch diameter, were mounted at two cathodes of a batch magnetron sputtering device. Next, the scattering layer substrate was mounted at a substrate holder of the device. After the sputtering device was evacuated to be less than or equal to $1 \times 10^{-3}$ Pa, the substrate heater was set to be 250 °C. After the scattering layer substrate was heated, 25 sccm of argon gas and 25 sccm of oxygen gas were introduced as the atmospheric gas. Next, a TZO layer was formed at a half surface of the scattering layer substrate using the target 1 by the DC pulse sputtering with an input electric power of 1000 W as the light extraction assistance layer. The thickness of the TZO layer was 70 nm.
The patterns of the light extraction assistance layer were the same as those shown in Fig. 4. Hereinafter, the scattering layer substrate is referred to as a "light extraction assistance layer substrate".

(Forming of first electrode)

Next, the first electrode (the ITO electrode) was formed on the light extraction assistance layer substrate by the following method.

First, after the substrate heater was switched off, the sputtering device was opened to the atmosphere and the mask made of glass was exchanged for a mask for forming ITO. Thereafter, the sputtering device was evacuated again to be less than or equal to $1 \times 10^{-3}$ Pa and the substrate heater was set to be 250 °C. After the light extraction assistance layer substrate was heated, 98 sccm of argon gas and 2 sccm of oxygen gas were introduced as the atmospheric gas. Next, the ITO layer was formed on the light extraction assistance layer substrate using the target 2 by the DC pulse sputtering with an input electric power 300 W. Then, after the substrate heater was switched off, the sputtering device was opened to the atmosphere, and the light extraction assistance layer substrate on which the ITO layer was formed is extracted. The thickness of the ITO layer was 150 nm. The patterns of the electrode were the same as those shown in Fig. 5.

(Manufacturing of organic EL element)

Four organic EL elements having different kinds of structures were manufactures by forming an organic light emitting layer and a second electrode on the light extraction assistance layer substrate with the ITO layer as obtained by the above steps.

The thickness of each of the hole transport layer, the light emitting layer, the electron transport layer, and the electron injection layer composing the organic light emitting layer, and the thickness of the second electrode were the values of table 6 obtained in the above described calculation. Further, each of the patterns was the same as that shown in Fig. 7.

The method of washing each of the substrates, the method of forming layers, and the method of sealing the organic EL elements were the same as those of the first example.

The light emitting layer, in other words, $Alq_3$ layer including 2 weight % of DCJTB, was formed by a co-evaporation of $Alq_3$ with DCJTB.

The obtained substrate was divided into four pieces by the same method as the first example to obtain four organic EL elements. In the following, the organic EL element without the scattering layer and the light extraction assistance layer is referred to as sample 1, the organic EL element with the scattering layer but without the light extraction assistance layer is referred to as sample 2, the organic EL element with the scattering layer and the light extraction assistance layer is referred to as sample 3. The organic EL element with the light extraction assistance layer but without the scattering layer was not used for the evaluations in the following.

(Evaluation of optical characteristics of each sample)

Similar to the first example, the optical characteristics of each of the samples 1 to 3 were evaluated. The device used and the measurement conditions are the same as those of the first example.

Table 7 shows the result.

[Table 7]

| ORGANIC EL ELEMENT | LUMINOUS FLUX [lm] | RELATIVE VALUE |
| --- | --- | --- |
| SAMPLE 1 | 0.016 | 1.00 |
| SAMPLE 2 | 0.017 | 1.11 |
| SAMPLE 3 | 0.024 | 1.52 |

As shown in table 7, it was confirmed that for the sample 2, the luminous flux was improved 1.11 times compared with the sample 1. Further, for the sample 3, the luminous flux was improved 1.52 times compared with the sample 1, and the luminous flux was improved 1.37 times compared with the sample 2.

The theory of the result is explained in the following.

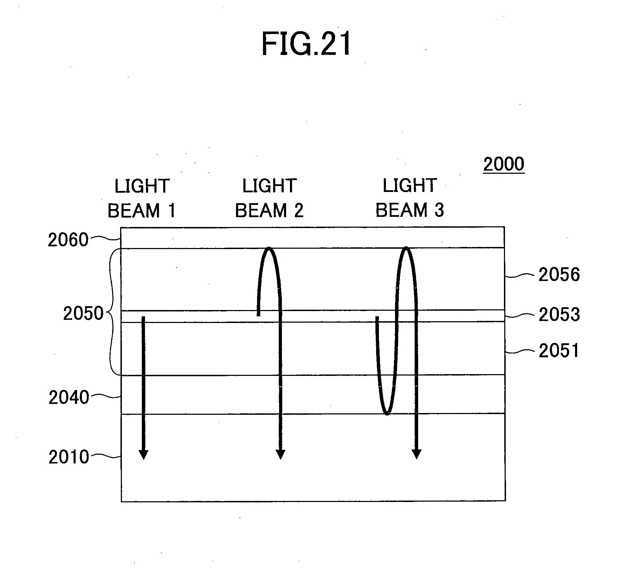

Fig. 21 is a schematic cross-sectional view of the organic EL element 2000 of the sample 1. In this sample 1, the organic EL element 2000 includes the soda lime substrate 2010, the first electrode 2040, the organic light emitting layer 2050 and the second electrode 2060. The organic light emitting layer 2050 includes the hole transport layer 2051, the light emitting layer 2053 and the layer 2056 including the electron transport layer and the electron injection layer.

Further, in Fig. 21, main light beams, which are emitted in a direction perpendicular to the soda lime substrate 2010, are shown.

A light beam 1 corresponds to a path of light from the light emitting layer 2053 emitted toward the soda lime substrate 2010 side and directly transmitted to the atmosphere side without being reflected at any surfaces. A light beam 2 corresponds to a path of a light from the light emitting layer 2053 emitted toward the second electrode 2060 side, reflected by the second electrode 2060 to be transmitted to the atmosphere side through the first electrode 2040 and the soda lime substrate 2010. Further, a light beam 3 corresponds to a path of a light from the light emitting layer 2053 emitted to the soda lime substrate 2010 side, reflected by the interface between the first electrode 2040 and the soda lime substrate 2010, thereafter, further reflected by the second electrode 2060 to be finally transmitted to the atmosphere side through the first electrode 2040 and the soda lime substrate 2010.

The reflectance of the light at an interface becomes larger as the difference of the refraction indexes of the materials forming the interface becomes larger. As the refraction index of the material such as ITO or the like composing the first electrode 2040 is about 2.0, which is generally relatively high, the difference of the refraction indexes between the soda lime substrate 2010 becomes larger so that the reflected light at the interface causes interference. Here, although reflection may occur at other interfaces, there are many cases where the difference of the refraction indexes of the substances forming such interfaces is small, and such influence is not considered here.

In order to improve the light extracting efficiency of the organic EL element 2000, it is effective to adjust the thickness of the layer 2056 provided between the light emitting layer 2053 and the second electrode 2060 such that the phases of the light beam 1 and the light beam 2 match. With this, the portion of the light that exits in a direction perpendicular to the soda lime substrate 2010 can be increased and further the light extracting efficiency can be improved.

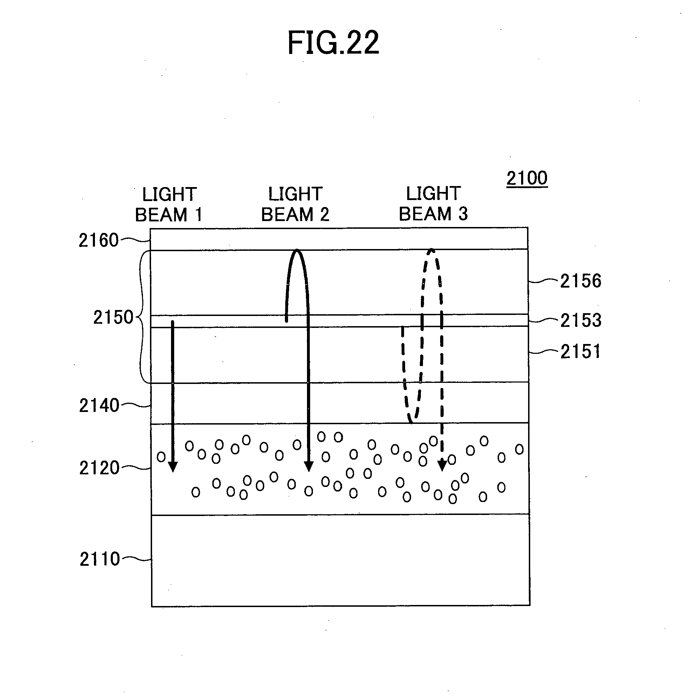

Next, Fig. 22 is a schematic cross-sectional view showing the organic EL element 2100 of the sample 2. In the sample 2, the organic EL element 2100 includes the soda lime substrate 2110, the scattering layer 2120, the first electrode 2140, the organic light emitting layer 2150 and the second electrode 2160. The organic light emitting layer 2150 includes the hole transport layer 2151, the light emitting layer 2153 and a layer 2156 including the electron transport layer and the electron injection layer.

Further, in Fig. 22, main light beams, which are emitted in a direction perpendicular to the soda lime substrate 2110, are shown.

At this time as well, the light beam 1 and the light beam 2 show behaviors similar to those of the case of Fig. 21. However, the influence of the interference by the light beam 3 is reduced. This is because the refraction index of the scattering layer 2120 is high and it is closer to the refraction index of the first electrode 2140. At this time, the reflectance of the light at the interface between the scattering layer 2120 and the first electrode 2140 becomes lower and the light quantity becomes smaller so that the influence of the light beam 3 for the interference becomes smaller.

As such, for the case of the sample 2, the contribution of the light beam 3 is small and it is difficult to get the interference effect. Thus, it becomes hard to gather the emitted lights at the front. It means that for the structure of the sample 2, although it is possible to increase the light extracting efficiency by introducing the light into the scattering layer 2120 having the high refraction index to be transmitted to the atmosphere after being scattered, the effect becomes small. However, it is estimated that the light extracting efficiency can be improved by adjusting the angles of the lights injected into the scattering layer 2120 to the front (ejected side).

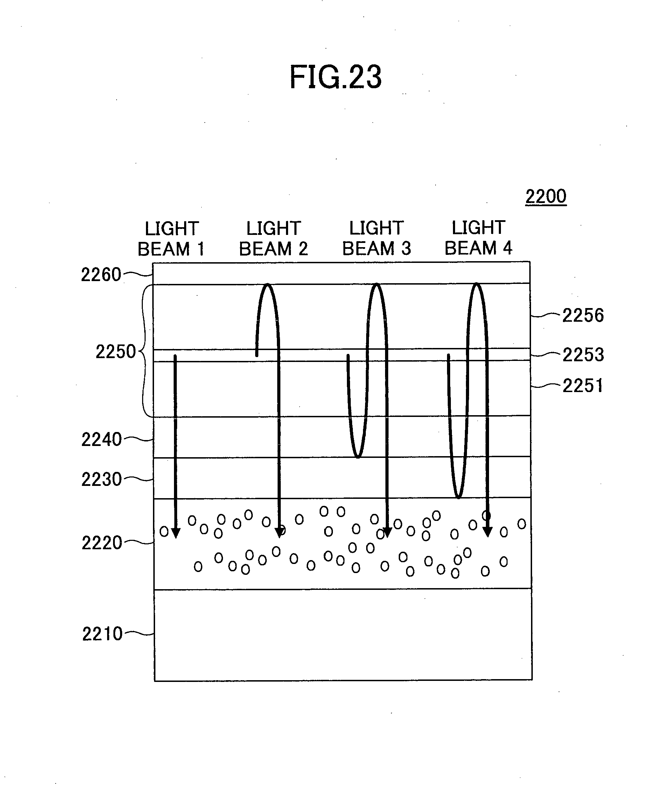

Fig. 23 is a schematic cross-sectional view showing the organic EL element 2200 of the sample 3. For the sample 3, the organic EL element 2200 includes the soda lime substrate 2210, the scattering layer 2220, the light extraction assistance layer 2230, the first electrode 2240, the organic light emitting layer 2250 and the second electrode 2260. The organic light emitting layer 2250 includes the hole transport layer 2251, the light emitting layer 2253, and the layer 2256 including the electron transport layer and the electron injection layer.

Further, in Fig. 23, main light beams, which are emitted in a direction perpendicular to the soda lime substrate 2210, are shown.

With this structure, the refraction index of the light extraction assistance layer 2230 can be set higher compared with those of the scattering layer 2220 and the first electrode 2240 so that the reflectance can be increased at the interface between the first electrode 2240 and the light extraction assistance layer 2230, and the interface between the light extraction assistance layer 2230 and the scattering layer 2220.

This corresponds to path of the light beam 3 and the light beam 4 in Fig. 23. When the phases of the light beam 3 and the light beam 4 are matched to the light beam 1 and the light beam 2, components in a front direction in the emitted lights can be increased and the light extracting efficiency can be further increased.

Here, as can be understood from table 6, the optimum thickness of the hole transport layer 2251 in the sample 3 was 90 nm. However, in the sample 1, this value is one of the worst values for the light extracting efficiency.

The reason that the opposing results as such were obtained is considered as follows.

In the sample 1, the reflection at the interface between the first electrode 2040 and the soda lime substrate 2010 as shown by the light beam 3 in Fig. 21 is a reflection of a light transmitted from a substance having a higher refraction index to a substance having a lower index and the phase is shifted for n (180°) by the reflection.

On the other hand, in Fig. 23, the refraction index of the light extraction assistance layer 2230 is higher than the refraction indexes of the first electrode 2240 and the scattering layer 2220. Thus, for example, the reflection at the interface between the first electrode 2240 and the light extraction assistance layer 2230 as shown by the light beam 3 in Fig. 23 is a reflection of a light transmitted from a substance having a relatively lower refraction index to a substance having a relatively higher refraction index and the phase shift does not occur.

Therefore, when applying the layers optimized by the structure of the sample 1 to the structure of the sample 3, the phase of the light beam 3 shown in Fig. 23 shifts by n and the light extracting efficiency is significantly lowered.

On the other hand, when the thicknesses of the layers of the optimized structure of the sample 1 are known, for example, the thickness of the hole transport layer 2051 may be changed such that the phase is shifted by n. Specifically, when the varied thickness of the hole transport layer 2051 is d1, the refraction index is n1, and the wavelength of the light is λ, the following equation may be satisfied.

$$d1 \ / \ (\lambda \ / \ n1) \ = \ \pm \ 0.5 \ \pm \ I$$

(I is an integer larger than or equal to 0)

Here, the method of generating such a difference in phase is not limited to the method of varying the thickness of the hole transport layer. For example, the thickness of the first electrode may be varied. For example, when a doping layer is used for the hole transport layer, the layer absorbs light within visible light area. Thus, if the layer is thickened, the absorption increases and the light extracting efficiency by the scattering layer is lowered. For such a case, the first electrode may be made thicker instead of the hole transport layer to adjust the phase of the light beam 3 to those of the light beam 1 and the light beam 2.

Further, the thicknesses of the first electrode and the hole transport layer may be varied at the same time. For a general-purpose organic EL element, there is a case where a hole injection layer is placed on the first electrode. The same can be said for the case when the hole injection layer exists. It means that by appropriately varying the thicknesses of the first electrode, the hole injection layer and the hole transport layer, the phase of the light beam 3 can be matched with those of the light beam 1 and the light beam 2.

In Fig. 23, for the case of the light beam 4, the reflection at the interface between the light extraction assistance layer 2230 and the scattering layer 2220 is a reflection of light transmitted from a substance having a relatively higher refraction index to a substance having a relatively lower refraction index and the phase shifts for n. In order to match the phase of the light beam 4 to that of the light beam 3, when the refraction index of the light extraction assistance layer 2230 is n2, the thickness is d2 and the wavelength is λ, the following equation may be satisfied.

$$d2 \ / \ (\lambda \ / \ n2) \ = \ \pm \ 0.5 \ \pm \ I$$

(1 is an integer larger than or equal to 0)

It can be understood that the calculation results shown in Fig. 18A to Fig. 20B reflect such a theory.

Although a preferred embodiment of the embodiment has been specifically illustrated and described, it is to be understood that minor modifications may be made therein without departing from the spirit and scope of the invention as defined by the claims.

The present application is based on and claims the benefit of priority of Japanese Priority Application No. 2010-238983 filed on October 25, 2010, and Japanese Priority Application No. 2011-101847 filed on April 28, 2011, the entire contents of which are hereby incorporated by reference.

[Industrial applicability]

The present invention is applicable to an organic EL element used in a light emitting device or the like.

[Numerals]

| | |
|---|---|
| 100 | organic EL element of embodiment |
| 110 | transparent substrate |
| 120 | scattering layer |
| 121 | base material |
| 124 | scattering substances |

| 130 | the light extraction assistance layer |
|---|---|
| 140 | first electrode (anode) |
| 150 | organic light emitting layer |
| 160 | second electrode (cathode) |
| 170 | light extraction surface |
| 310 | soda lime substrate |
| 320 | scattering layer |
| 330 | light extraction assistance layer |
| 350 | ITO layer |
| 360 | layer of $\alpha$-NPD and Alq$_3$ |
| 370 | layer of LiF and Al |
| 390 | area |
| 410 | light extraction assistance layer substrate |
| 700 | translucent substrate |
| 1000 | measurement device |
| 1010 | lightmeter |
| 1020 | sample |
| 1500 | organic EL element |
| 1510 | glass substrate |
| 1540 | first electrode |
| 1550 | organic light emitting layer |
| 1551 | hole transport layer |
| 1553 | light emitting layer |
| 1555 | electron transport layer |
| 1557 | electron injection layer |
| 1560 | second electrode |
| 1600 | organic EL element |
| 1620 | scattering layer matrix glass |
| 1640 | first electrode |
| 1650 | organic light emitting layer |
| 1651 | hole transport layer |
| 1653 | light emitting layer |
| 1655 | electron transport layer |
| 1657 | electron injection layer |
| 1660 | second electrode |
| 1700 | organic EL element |
| 1720 | scattering layer matrix glass |
| 1730 | the light extraction assistance layer |
| 1740 | first electrode |
| 1750 | organic light emitting layer |
| 1751 | hole transport layer |
| 1753 | light emitting layer |
| 1755 | electron transport layer |
| 1757 | electron injection layer |
| 1760 | second electrode |
| 2000, 2100, 2200 | organic EL element |
| 2010, 2110, 2210 | soda lime substrate |
| 2120, 2220 | scattering layer |
| 2230 | light extraction assistance layer |
| 2040, 2140, 2240 | first electrode |
| 2050, 2150, 2250 | organic light emitting layer |
| 2051, 2151, 2251 | hole transport layer |
| 2053, 2153, 2253 | light emitting layer |
| 2056, 2156, 2256 | layer including electron transport layer and electron injection layer |
| 2060, 2160, 2260 | second electrode |

**Claims**

1. An organic EL element comprising:

   a transparent substrate;
   a first electrode;
   an organic light emitting layer formed on the first electrode; and
   a second electrode formed on the organic light emitting layer,
   wherein a scattering layer including a base material made of glass and scattering substances dispersed in the base material is provided on the transparent substrate, and
   a light extraction assistance layer is provided between the scattering layer and the first electrode, the light extraction assistance layer being made of an inorganic material other than glass.

2. The organic EL element according to claim 1, wherein the light extraction assistance layer has a refraction index more than or equal to 2.2 within a wavelength range of 430 nm to 650 nm.

3. The organic EL element according to claim 1, wherein the light extraction assistance layer is made of a material selected from a group including Ti containing nitride, Ti containing oxide and Ti containing nitride-oxide.

4. The organic EL element according to claim 3, wherein the light extraction assistance layer is made of $TiZr_xO_y$ or $TiO_2$.

5. The organic EL element according to claim 1, wherein the thickness of the light extraction assistance layer is less than or equal to 50 nm.

6. A translucent substrate comprising a transparent substrate and a transparent electrode, wherein
   a scattering layer including a base material made of glass and scattering substances dispersed in the base material is provided on the transparent substrate, and
   a light extraction assistance layer is provided between the scattering layer and the transparent electrode, the light extraction assistance layer being made of an inorganic material other than glass.

7. The translucent substrate according to claim 6, wherein the light extraction assistance layer has a refraction index more than or equal to 2.2 within a wavelength range of 430 nm to 650 nm.

8. A method of manufacturing an organic EL element, comprising:

   forming a scattering layer on a transparent substrate;
   providing a light extraction assistance layer on the scattering layer;
   providing a first electrode on the light extraction assistance layer;
   providing an organic light emitting layer on the first electrode; and
   providing a second electrode on the organic light emitting layer.

9. The method of manufacturing an organic EL element according to claim 8, wherein the light extraction assistance layer is provided to have a refraction index more than or equal to 2.2 within a wavelength range of 430 nm to 650 nm.

10. The method of manufacturing an organic EL element according to claim 8, wherein the light extraction assistance layer is provided to be made of a material selected from a group including Ti containing nitride, Ti containing oxide and Ti containing nitride-oxide.

11. The method of manufacturing an organic EL element according to claim 10, wherein the light extraction assistance layer is provided to be made of $TiZr_xO_y$ or $TiO_2$.

12. The method of manufacturing an organic EL element according to claim 8, wherein the light extraction assistance layer is provided such that the thickness of the light extraction assistance layer becomes less than or equal to 50 nm.

# FIG.1

# FIG.2

START

S110

FORM SCATTERING LAYER ON
TRANSPARENT SUBSTRATE

S120

FORM LIGHT EXTRACTION ASSISTANCE LAYER
ON SCATTERING LAYER

S130

FORM FIRST ELECTRODE ON
LIGHT EXTRACTION ASSISTANCE LAYER

S140

FORM ORGANIC LIGHT EMITTING LAYER
ON FIRST ELECTRODE

S150

FORM SECOND ELECTRODE ON
ORGANIC LIGHT EMITTING LAYER

END

# FIG.3

320

50mm

310

320

L3

50mm

# FIG.4

320

410

330

310

320

# FIG.5

FIG.6

# FIG.7

# FIG.8

EP 2 635 091 A1

# FIG.9

# FIG.10

# FIG.11

EP 2 635 091 A1

# FIG.12

# FIG.13

EP 2 635 091 A1

# FIG.14

EP 2 635 091 A1

# FIG.15

1500

# FIG.16

1600

# FIG.17

1700

1760

1757

1755

1753

1751

1750

1740

1730

1720

# FIG.18A

# FIG.18B

FIG.19A

EP 2 635 091 A1

FIG.19B

FIG.20A

EP 2 635 091 A1

FIG.20B

EP 2 635 091 A1

# FIG.21

LIGHT BEAM 1  LIGHT BEAM 2  LIGHT BEAM 3  2000

2060
2050
2040
2010

2056
2053
2051

# FIG.22

# FIG.23

## INTERNATIONAL SEARCH REPORT

| | International application No. |
|---|---|
| | PCT/JP2011/074358 |

A. CLASSIFICATION OF SUBJECT MATTER
*H05B33/02*(2006.01)i, *H01L51/50*(2006.01)i, *H05B33/10*(2006.01)i

According to International Patent Classification (IPC) or to both national classification and IPC

B. FIELDS SEARCHED

Minimum documentation searched (classification system followed by classification symbols)
H05B33/02, H01L51/50, H05B33/10

Documentation searched other than minimum documentation to the extent that such documents are included in the fields searched
Jitsuyo Shinan Koho 1922–1996 Jitsuyo Shinan Toroku Koho 1996–2011
Kokai Jitsuyo Shinan Koho 1971–2011 Toroku Jitsuyo Shinan Koho 1994–2011

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2009/116531 A1 (Asahi Glass Co., Ltd.), 24 September 2009 (24.09.2009), paragraphs [0008], [0055] to [0059], [0068] to [0070], [0077] to [0082]; fig. 1, 12, 14 & US 2011/0001159 A1 & EP 2278852 A1 & CN 101978781 A & KR 10-2010-0138939 A | 1-12 |
| X | JP 2009-110930 A (Fujifilm Corp.), 21 May 2009 (21.05.2009), paragraphs [0023], [0072], [0078]; fig. 3 to 5 & US 2009/0052195 A1 & KR 10-2009-0019752 A | 1-4,6-11 |
| Y | | 5,12 |
| Y | JP 2009-259802 A (Fujifilm Corp.), 05 November 2009 (05.11.2009), paragraph [0072]; fig. 2 (Family: none) | 5,12 |

☒ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 16 November, 2011 (16.11.11) | 29 November, 2011 (29.11.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2011/074358 |

C (Continuation).   DOCUMENTS CONSIDERED TO BE RELEVANT

| Category* | Citation of document, with indication, where appropriate, of the relevant passages | Relevant to claim No. |
| --- | --- | --- |
| X | JP 2008-538155 A  (Eastman Kodak Co.),<br>09 October 2008 (09.10.2008),<br>paragraphs [0021], [0022], [0032]; fig. 5<br>& US 2006/0186802 A1    & EP 1851810 A<br>& WO 2006/091614 A1 | 1,6,8 |
| A | WO 2009/060916 A1  (Asahi Glass Co., Ltd.),<br>14 May 2009 (14.05.2009),<br>fig. 1<br>& US 2010/0230667 A1    & EP 2219416 A1<br>& CN 101855939 A        & KR 10-2010-0101076 A | 1-12 |

Form PCT/ISA/210 (continuation of second sheet) (July 2009)

**EP 2 635 091 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2009060916 A1
- JP 2010198797 A
- JP 2010238983 A
- JP 2011101847 A